# EUROPÄISCHE PATENTSCHRIFT

(11) **EP 2 720 051 B1**
(45) Veröffentlichungstag und Bekanntmachung des Hinweises auf die Patenterteilung: **21.01.2015**
(21) Anmeldenummer: 12188000.9
(22) Anmeldetag: 10.10.2012
(51) Int. Cl.: H02H 3/10, H02H 3/18, G05B 9/02, G05B 23/02, G01R 31/02

(54) **Sicherheitssystem**
Safety system
Système de sécurité

(43) Veröffentlichungstag der Anmeldung: 16.04.2014
(73) Patentinhaber: SICK AG, 79183 Waldkirch/Breisgau (DE)
(72) Erfinder: Henneberger, Stephan, 79115 Freiburg (DE)
(74) Vertreter: Manitz, Finsterwald & Partner GbR

(56) Entgegenhaltungen:
- EP-A1- 2 362 408
- DE-A1-102011 016 137

## Beschreibung

Die vorliegende Erfindung betrifft ein Anschaltungsmodul für ein Sicherheitssystem und ein Sicherheitssystem, welches beispielsweise zur Erkennung eines Gefahrenfalls bei einer sicherheitskritischen Anlage oder Maschine und zur Durchführung einer Sicherheitsabschaltung in dem Gefahrenfall einsetzbar ist.

Sicherheitssysteme der betreffenden Art umfassen üblicherweise eine z.B. als Sicherheitssteuerung ausgebildete Sicherheitseinheit mit einem Ausgang und einem Sicherheitseingang und mit wenigstens einem ein Schutzgerät umfassenden Sicherheitsteilnehmer, wobei eine mit dem Ausgang und dem Sicherheitseingang verbundene Testsignalleitung bzw. Busleitung mit dem Sicherheitsteilnehmer einen Testsignalpfad zur Übertragung eines von der Sicherheitssteuerung erzeugten dynamischen Testsignals bildet und wobei das Schutzgerät dazu ausgebildet ist, bei Vorliegen bzw. Eintreten eines nicht sicheren Zustandes eine Unterbrechung des Testsignalpfads zu bewirken. Beispielsweise kann dazu ein in dem Testsignalpfad angeordneter Schalter des Schutzgerätes, der als unmittelbarer Übertragungsweg für das Testsignal genutzt wird, geöffnet werden, so dass der Testsignalpfad unterbrochen wird. Bleibt das erwartete Testsignal an dem Sicherheitseingang der Sicherheitssteuerung aufgrund einer solchen Unterbrechung aus, kann die Sicherheitssteuerung eine Sicherheitsmaßnahme ergreifen und zum Beispiel die Stromzufuhr zu einer sicherheitskritischen Anlage unterbrechen und diese dadurch abschalten, wodurch das Sicherheitssystem seine Sicherheitsfunktion erfüllt.

Um besonders hohen Anforderungen an die erreichte Sicherheit zu genügen, werden mehrkanalige Schutzgeräte eingesetzt, wie z.B. zweikanalig äquivalent öffnende Sicherheitsschaltgeräte mit einem ersten und einem zweiten Schalter, die bei dem Eintreten eines nicht sicheren Zustands des Schutzgeräts gemeinsam unterbrochen werden. Die beiden Schalter können dabei in dem gemeinsamen Testsignalpfad angeordnet und elektrisch in Serie geschaltet sein, so dass bereits das Öffnen eines der beiden Schalter zu einer Sicherheitsabschaltung führt und im Ergebnis eine Redundanz der durch den Sicherheitsteilnehmer bereitgestellten Schutzfunktion geschaffen wird.

Ein Sicherheitssystem kann auch mehrere an die Busleitung angeschlossene Sicherheitsteilnehmer aufweisen, die z.B. örtlich über, die Anlage verteilt angeordnet sein können, wobei ein nicht sicherer Zustand eines beliebigen Schutzgeräts jeweils zu dem Ansprechen der Sicherheitsfunktion führt.

EP 2 362 408 A1 offenbart ein Sicherheitsschaltgerät mit zwei Paaren von jeweils einem Signaleingang und einem Signalausgang, zwischen denen jeweils ein Schaltpfad eines Not-Stopp-Schaltgeräts angeschlossen ist, wobei das Sicherheitsschaltgerät dazu eingerichtet ist, die beiden Schaltpfade jeweils zu testen, wobei das Testen eines Schaltpfads das Übertragen eines Testsignals über den Schaltpfad umfasst.

Aus EP 1 393 280 A1 ist ein Sicherheitssystem mit einer ringförmigen Busleitung bekannt, wobei an der ringförmigen Busleitung mehrere in einer ringförmigen Topologie angeordnete Sicherheitsteilnehmer bzw. Schutzgeräte angeschlossen und über die Busleitung in Serie geschaltet und dadurch kaskadiert sind. Die ringförmige Busleitung und die Schutzgeräte bilden dabei den Testsignalpfad für das Testsignal. Das Testsignal durchläuft der Reihe nach alle Schutzgeräte der Kaskade, wobei diese jeweils zur Unterbrechung des Testsignalpfads bei dem Auftreten eines nicht sicheren Zustands eingerichtet sind, so dass das Testsignal bei fehlerfreier Funktion des Sicherheitssystems nur dann zur Sicherheitseinheit zurückgeführt wird, wenn alle Schutzgeräte sich in ihrem sicheren Zustand befinden. Das an dem Eingang der Sicherheitseinheit empfangene Testsignal stellt somit eine Summeninformation bereit, die angibt, ob sich alle Schutzgeräte in ihrem sicheren Zustand befinden oder nicht.

Die direkte Einbindung der Schutzgeräte in eine solche ringförmige Busleitung führt bei der Verwendung einer Mehrzahl von Schutzgeräten zu einem erheblichen Verkabelungsaufwand, da jeweils ein Abschnitt der ringförmigen Busleitung erforderlich ist, der zu dem jeweiligen Schutzgerät hin läuft, und ein davon getrennter weiterer Abschnitt der Busleitung, der von dem Schutzgerät weg läuft, was abhängig von der örtlichen Verteilung der Schutzgeräte zueinander eine hohe Gesamtlänge der Busleitung bedingt.

Um den Verkabelungsaufwand zu reduzieren, ist es prinzipiell möglich, die örtlich verteilten Schutzgeräte jeweils über ein an die Busleitung angeschlossenes Anschaltungsmodul an die Busleitung anzubinden, wobei das Schutzgerät jeweils über eine einzelne Anschaltungsleitung nach der Art einer Stichleitung mit dem Anschaltungsmodul verbunden und dadurch an die Busleitung angeschlossen und in den Testsignalpfad eingebunden ist. Bei einer solchen Topologie besteht jedoch die Gefahr eines Fehlers in Form eines Querschlusses zwischen den in der gemeinsamen Anschaltungsleitung geführten Leitungspfaden. Beispielsweise besteht bei der Anbindung eines zwei Schalter aufweisenden zweikanaligen Schutzgeräts über eine gemeinsame Anschaltungsleitung die Gefahr eines Querschlusses zwischen den beiden Schutzkanälen, d.h. zwischen einem mit einem der Schalter verbundenen Hinleiter oder Rückleiter und einem mit dem anderen Schalter verbundenen Hinleiter oder Rückleiter. Ein solcher Querschluss führt zur Überbrückung eines der Schalter. Im Falle einer unmittelbaren elektrischen Serienschaltung der durch die beiden Schalter zusammen mit dem jeweiligen Hin- und Rückleiter gebildeten Schaltpfade in dem Anschaltungsmodul bedeutet eine solche Überbrückung eines Schalters, dass ein Öffnen des überbrückten Schalters ohne Auswirkungen auf die Übertragung des Testsignals über die Serienschaltung beider Schaltpfade bleibt. Dadurch geht die Schutzwirkung dieses überbrückten Schalters und die dadurch bezweckte Redundanz des zweikanaligen Schutzgeräts verloren, ohne dass dies durch die Sicherheitseinheit festgestellt wird. Dadurch wird die Sicherheit des Sicherheitssystems beeinträchtigt.

Aufgabe der Erfindung ist es, ein Anschaltungsmodul zur Einbindung eines Schutzgeräts in ein Sicherheitssystem und ein Sicherheitssystem der eingangs genannten Art anzugeben, wobei das Sicherheitssystem mit geringem Verkabelungsaufwand bereitgestellt werden kann und gleichzeitig ein hohes Sicherheitsniveau gewährleistet.

Zur Lösung dieser Aufgabe ist ein Anschaltungsmodul mit den Merkmalen des Anspruchs 1 beziehungsweise ein Sicherheitssystem mit den Merkmalen des Anspruchs 9 vorgesehen.

Die Unteransprüche 2 bis 8 beschreiben vorteilhafte Ausführungsformen des Anschaltungsmoduls und die Unteransprüche 10 bis 14 beschreiben vorteilhafte Ausführungsformen des erfindungsgemäßen Sicherheitssystems. Vorteilhafte Ausführungsformen und Vorteile des Anschaltungsmoduls sind in der vorliegenden Beschreibung teilweise unter Bezugnahme auf das Sicherheitssystem beschrieben.

Das Sicherheitssystem gemäß Anspruch 9 umfasst:
- eine Sicherheitseinheit, insbesondere Sicherheitssteuerung, mit einem Ausgang und einem Sicherheitseingang,
- eine zwischen dem Ausgang und dem Sicherheitseingang der Sicherheitseinheit angeordnete Busleitung, und
- wenigstens einen an die Busleitung angeschlossenen Sicherheitsteilnehmer, welcher ein an die Busleitung angeschlossenes Anschaltungsmodul nach zumindest einem der Ansprüche 1 bis 8 umfasst, welches einen Testsignaleingang für ein eingehendes Testsignal und
einen Testsignalausgang für ein ausgehendes Testsignal umfasst. Die Busleitung und der Sicherheitsteilnehmer bilden einen Testsignalpfad mit einem mit dem Ausgang der Sicherheitseinheit verbundenen Hinleitungspfad und einem mit dem Sicherheitseingang der Sicherheitseinheit verbundenen Rückleitungspfad, wobei der Testsignalpfad den zwischen dem Testsignaleingang und dem Teststsignalausgang angeordneten Testsignalpfad des Anschaltungsmoduls umfasst. Der Sicherheitsteilnehmer umfasst ein über eine Anschaltungsleitung mit dem Anschaltungsmodul verbundenes und über das Anschaltungsmodul in den Testsignalpfad eingebundenes Schutzgerät. Das Schutzgerät umfasst zwei Schalter, die jeweils über einen Hinleiter und einen Rückleiter der Anschaltungsleitung und über eines der Paare von einem Signaleingang und einem Signalausgang des Anschaltungsmoduls zur Bildung des ersten und zweiten elektrischen Schaltpfads mit dem Anschaltungsmodul verbunden und in den Testsignalpfad eingebunden sind.

Als Schutzgerät kann zum Beispiel ein sicheres Schutzgerät eingesetzt werden, welches zumindest zwei Schalter umfasst und welches dazu ausgebildet ist, abhängig von einer für die Sicherheit z.B. einer Person relevanten äußeren Einwirkung einen sicheren Zustand anzunehmen, in dem die Schalter geschlossen sind, oder einen nicht sicheren Zustand, in dem die Schalter geöffnet sind. Beispielsweise kann es sich um einen Not-Aus-Taster handeln, der wenigstens zwei Schalter umfasst, die im sicheren, d.h. nicht betätigten, Zustand des Not-Aus-Tasters geschlossen sind und die im nicht sicheren, d.h. betätigten, Zustand des Not-Aus-Tasters geöffnet sind. Ein weiteres Beispiel ist eine Zuhaltungseinrichtung einer Sicherheitstür, die zumindest zwei Schalter aufweist, die in der sicheren, d.h. geschlossenen, Stellung der Tür geschlossen sind und die in der nicht sicheren, d.h. geöffneten, Stellung der Tür geöffnet sind. Das Schutzgerät kann zusätzlich zu den zumindest zwei Schaltern auch noch einen oder mehrere weitere Schalter umfassen, die, beispielsweise über eine wie nachstehend beschriebene Testschaltung, in den Testsignalpfad seriell zur Bildung eines elektrischen Schaltpfads eingeschaltet sein können, so dass sie den Testsignalpfad abhängig von ihrem Schaltzustand schließen oder unterbrechen.

Das Anschaltungsmodul umfasst eine Testschaltung für die zumindest zwei Schaltpfade, welche zumindest eine gesteuerte Stromquelle, eine gesteuerte Stromsenke und ein Stromrichtungselement umfasst. Dabei ist der Testsignaleingang des Anschaltungsmoduls mit einem Steuereingang der gesteuerten Stromquelle oder der gesteuerten Stromsenke verbunden, so dass die gesteuerte Stromquelle oder Stromsenke durch das eingehende Testsignal oder ein davon abgeleitetes Signal ansteuerbar ist. Ein gesteuerter Ausgang derselben von Stromquelle und Stromsenke ist mit dem Hinleiter des ersten Schaltpfads verbunden, um einen Strom über den ersten Schaltpfad zu übertragen. Der Rückleiter des ersten Schaltpfads ist mit dem Steuereingang der jeweils anderen der gesteuerten Stromquelle und der gesteuerten Stromsenke verbunden, so dass die gesteuerte Stromquelle oder Stromsenke durch das über den ersten Schaltpfad übertragene Stromsignal oder ein davon abgeleitetes Signal ansteuerbar ist.

Ein gesteuerter Ausgang der anderen der gesteuerten Stromquelle und Stromsenke der Testschaltung ist mit dem Hinleiter des zweiten Schaltpfads verbunden, um einen Strom über den zweiten Schaltpfad zu übertragen.

Der Rückleiter des zweiten Schaltpfads ist mit dem Stromrichtungselement, direkt oder indirekt, verbunden, welches dazu ausgebildet ist, ein von dem über den zweiten Schaltpfad übertragenen Strom, insbesondere von dessen Richtung, abhängiges Signal zu liefern. Schließlich ist der Testsignalausgang des Anschaltungsmoduls mit dem Stromrichtungselement verbunden, um das von dem Stromrichtungselement erzeugte Signal oder ein davon abgeleitetes Signal als ausgehendes Testsignal des Sicherheitsteilnehmers auszugeben.

Das vorstehend beschriebene Sicherheitssystem erfordert einen deutlich verringerten Verkabelungsaufwand und weist gleichzeitig ein hohes Sicherheitsniveau auf. In dem erfindungsgemäßen Sicherheitssystem ist ein als zweikanaliges Sicherheitsschaltgerät mit zwei Schaltern ausgebildetes Schutzgerät über eine einzelne Anschaltungsleitung und ein damit verbundenes Anschaltungsmodul an die Busleitung angeschlossen und in den Testsignalpfad eingebunden. Die Anschaltungsleitung bindet das Schutzgerät somit nach der Art einer von der Busleitung abgehenden Stichleitung in den Testsignalpfad ein, wodurch der Verkabelungsaufwand gegenüber einer Anbindung, bei der die ringförmige Busleitung direkt über das Schutzgerät geführt wird, erheblich verringert wird.

Durch die in dem Anschaltungsmodul vorgesehene Testschaltung wird dabei verhindert, dass ein in der Anschaltungsleitung auftretender Querschluss zwischen den beiden, jeweils einen Schalter des Schutzgeräts umfassenden elektrischen Schaltpfaden zu einem unbemerkten Verlust der durch die zwei Schalter bezweckten Redundanz der Schutzfunktion und somit einer Beeinträchtigung der Sicherheit führt. Stattdessen ist die Testschaltung dazu ausgebildet, im Falle eines solchen Querschlusses abweichend von ihrem Verhalten bei fehlerfreiem Betrieb keine ordnungsgemäße Übertragung bzw. Weitergabe des an dem Testsignaleingang empfangenen dynamischen Testsignals durchzuführen, sondern ein Signal an den Testsignalausgang zu liefern, welches die Erwartungshaltung der Sicherheitsschaltung an das dynamische Testsignal verletzt, was zu einem Ansprechen der Sicherheitsfunktion der Sicherheitseinheit führt.

Die Funktion der Testschaltung beruht darauf, dass im fehlerfreien Betrieb und im sicheren Zustand des Schutzgeräts der Strom durch den ersten und zweiten elektrischen Schaltpfad in unterschiedlichen Richtungen getrieben wird, da der Strom durch einen der elektrischen Schaltpfade von einer Stromquelle getrieben wird, die einen ausgehenden elektrischen Stromfluss erzeugt, und der Strom durch den anderen elektrischen Schaltpfad von einer Stromsenke getrieben wird, die einen eingehenden elektrischen Stromfluss erzeugt. Ein Querschluss zwischen beiden Schaltpfaden führt deshalb zu einer Richtungsumkehr des Stromflusses in dem mit dem Stromrichtungselement verbundenen elektrischen Schaltpfad oder zumindest zu einer Verringerung des Stromflusses in der erwarteten Richtung im Vergleich zu dem Stromfluss bei fehlerfreiem Betrieb, d.h. in Abwesenheit eines Querschlusses zwischen beiden Schaltpfaden. Das Stromrichtungselement kann das Vorliegen einer solchen Abweichung des Stromflusses von dem Stromfluss bei fehlerfreiem Betrieb erkennen und dafür sorgen, dass ein Testsignal an dem Testsignalausgang des Sicherheitsteilnehmers ausgeben bzw. angelegt wird, welches von dem bei fehlerfreien Betrieb übertragenen Testsignal abweicht und die Erwartungshaltung der Sicherheitseinheit verletzt und somit zu einem Ansprechen der Sicherheitsfunktion führt.

Dadurch wird vermieden, dass das Vorliegen eines wie vorstehend beschriebenen Querschlusses zwischen den beiden elektrischen Schaltpfaden in der Anschaltungsleitung unerkannt bleibt und zu einem Verlust der durch die zwei Schalter des Schutzgeräts bezweckten redundanten Schutzwirkung führt.

Da die Sicherheitsteilnehmer über die erfindungsgemäße Testschaltung und deren Komponenten elektrisch miteinander in Serie geschaltet sind und seriell in den Testsignalpfad eingebunden sind, ist sichergestellt, dass ein beispielsweise durch das Eintreten des nicht sicheren Zustands des Schutzgeräts verursachtes Öffnen zumindest eines Schalters oder eine Unterbrechung eines Hin- oder Rückleiters in der Anschaltungsleitung ebenfalls zu dem gewünschten Ansprechen der Sicherheitsfunktion führt. In diesem Fall erfolgt nämlich keine Anregung der Stromquelle und/oder Stromsenke durch das eingehende Testsignal. Somit wird in diesem Fall kein der Erwartungshaltung der Sicherheitseinheit entsprechendes Testsignal an dem Testsignalausgang des Sicherheitsteilnehmers ausgegeben. Die erfindungsgemäße Verschaltung entspricht also im Hinblick auf ihren seriellen Charakter einer herkömmlichen Serienschaltung, wobei zusätzlich eine wie vorstehend beschriebene Querschlusserkennung gewährleistet ist.

Auf diese Weise wird trotz der verkabelungstechnisch weniger aufwendigen Anbindung des Schutzgeräts an die Busleitung über eine einzelne von der Busleitung abgehende Stichleitung und der damit einhergehenden Möglichkeit eines Querschlusses zwischen den zwei Schaltpfaden ein hohes Sicherheitsniveau erreicht, so dass im Ergebnis ein Sicherheitssystem geschaffen wird, welches mit verringertem Aufwand bereitgestellt werden kann und gleichzeitig ein hohes Sicherheitsniveau aufweist. Es wird somit eine sichere, über eine einzelne Anschaltungsleitung ausführbare einkanalige Einbindung eines zweikanaligen Schutzgeräts in das Sicherheitssystem und eine sichere Abbildung des sicheren oder nicht sicheren Zustands des Schutzgeräts auf den Testsignalpfad erreicht.

Ein weiterer Vorteil der Erfindung besteht darin, dass die Testschaltung vollständig aus diskreten elektrischen oder elektronischen Elementen bzw. Bauteilen aufgebaut sein kann und die Dynamik der durch die Testschaltung erzeugten Signale allein durch die Dynamik des eingehenden Testsignals erzeugt werden kann. Die Testschaltung benötigt also zur Erzeugung der entsprechenden Signale keine von dem eingehenden Testsignal unabhängige Zeitbasis. Dadurch wird die Fehleranfälligkeit der Testschaltung auf ein Minimum reduziert. Außerdem kann die Testschaltung im funktionstüchtigen Betrieb des Sicherheitsteilnehmers ein Testsignal ausgeben, welches im Wesentlichen dem eingehenden Testsignal entspricht und gegenüber diesem insbesondere nicht oder zumindest nicht wesentlich verzögert ist, so dass der Betrieb des restlichen Sicherheitssystems durch die Testschaltung nicht gestört wird.

Vorteilhafte Ausführungsformen der Erfindung sind in den Unteransprüchen, der Beschreibung und den Figuren beschrieben.

Die Sicherheitseinheit kann prinzipiell eine Sicherheitskomponente wie z.B. ein Sicherheitsrelais, einen Sicherheitssensor, einen Sicherheitsaktor oder eine ähnliche Sicherheitskomponente umfassen, welche einen Ausgang und einen Sicherheitseingang für ein Ausgangssignal bzw. Testsignal aufweist.

Vorzugsweise ist die Sicherheitseinheit durch eine Sicherheitssteuerung gebildet, welche bevorzugt dazu eingerichtet ist, bei Ausbleiben des erwarteten Testsignals eine Sicherheitsmaßnahme durchzuführen und insbesondere eine überwachte Anlage oder eine damit verbundene Einrichtung aktiv anzusteuern, um die Anlage in einen sicheren Zustand zu überführen. Zum Beispiel kann die Sicherheitssteuerung eine Unterbrechung der Stromzufuhr zu der Anlage bewirken, insbesondere durch Ansteuerung eines in einer Stromzufuhrleitung angeordneten Relais. Die Sicherheitssteuerung kann eine digitale Logikeinheit umfassen, welche einen oder mehrere Mikroprozessoren umfassen kann und welche vorzugsweise das Aussenden des Ausgangssignals und/oder die Auswertung des eingehenden Testsignals steuert.

Wenn im Nachfolgenden die vorteilhaften Ausführungsformen der Erfindung unter Bezugnahme auf eine Sicherheitssteuerung erläutert sind, sind diese Erläuterungen allgemein auf die Anwendung der Erfindung auf eine Sicherheitseinheit zu beziehen, wobei die Realisierung der Erfindung mit einer Sicherheitssteuerung eine bevorzugte Ausführungsform darstellt.

Das Sicherheitssystem ist vorzugsweise dazu eingerichtet, ein dynamisches, d.h. zeitveränderliches, Testsignal zu erzeugen und über die Busleitung und den darin angeordneten Testleitungspfad zu dem Testsignaleingang des Sicherheitsteilnehmers zu übertragen. Dieses Testsignal wird vorzugsweise von der Sicherheitssteuerung erzeugt, kann aber gemäß einer im Weiteren beschriebenen speziellen Ausführungsform auch von einem Abschlusselement des Sicherheitssystems erzeugt werden. Das Testsignal ist vorzugsweise als binärwertiges Gleichstrom- oder Gleichspannungssignal ausgebildet, das zwischen einem vorgegebenen hohen Strom- bzw. Spannungspegel ("High") und einem vorgegebenen niedrigen Strom- bzw. Spannungspegel ("Low") wechselt. Beispielsweise kann das als Gleichspannungssignal ausgebildete Testsignal zwischen einem hohen Spannungspegel wie z.B. 24 Volt und einem niedrigen Spannungspegel wie z.B. 0 Volt oder Massepotential wechseln.

Vorzugsweise sind auch die Komponenten der Testschaltung dazu eingerichtet, zumindest im fehlerfreien Betrieb des Sicherheitsteilnehmers binärwertige Strom- bzw. Spannungssignale zu erzeugen, die jeweils zwischen einem hohen Signalpegel bzw. Strom- oder Spannungspegel ("High") und einem niedrigen Signalpegel bzw. Strom- oder Spannungspegel ("Low") wechseln.

Das dynamische Testsignal kann z.B. mit einer vorgegebenen Zykluszeit periodisch auftretende Testlücken mit einer vorgegebenen Dauer aufweisen, wobei das Signal während der Testlücken jeweils dauerhaft einen niedrigen Signalpegel aufweist und zwischen zwei aufeinander folgenden Testlücken einen dauerhaft hohen Signalpegel aufweist.

In der Sicherheitssteuerung ist bevorzugt eine Erwartungshaltung in Bezug auf das an dem Sicherheitseingang der Sicherheitssteuerung empfangene Testsignal abgelegt und die Sicherheitssteuerung ist dazu eingerichtet, zu überprüfen, ob das tatsächlich empfangene Testsignal dieser Erwartungshaltung entspricht, und andernfalls eine Sicherheitsmaßnahme durchzuführen bzw. zu veranlassen. Beispielsweise kann die Erwartungshaltung umfassen, dass das eingehende Testsignal eine erwartete Dynamik aufweist. Ebenso kann überprüft werden, dass eine maximale zulässige zeitliche Abweichung oder Verzögerung zwischen dem Zeitpunkt, zu dem eine Testlücke des eingehenden Testsignals erwartet wird, und dem tatsächlichen Auftreten einer Testlücke in diesem Testsignal nicht überschritten wird und/oder dass die Dauer einer Testlücke des eingehenden Signals einer erwarteten Testlückendauer entspricht. Somit führt zum Beispiel ein dauerhaftes Anliegen eines niedrigen Signalpegels ("Low") an der Sicherheitssteuerung, z.B. aufgrund einer Unterbrechung eines Schutzgeräts, zum Ansprechen der Sicherheitsfunktion und insbesondere zum Auslösen einer Sicherheitsabschaltung, ebenso wie ein Ausbleiben einer erwarteten Testlücke aufgrund eines so genannten "Stuck-at-High"-Fehlers, d.h. einem dauerhaft anliegenden hohen Signalpegel ("High").

Die gesteuerte Stromquelle kann als aktive Stromquelle, bevorzugt Gleichstromquelle, ausgebildet sein und dazu eingerichtet sein, an ihrem Ausgang aktiv einen, bezogen auf die technische Stromflussrichtung, positiven ausgehenden elektrischen Stromfluss zu erzeugen, der von dem an ihrem Steuereingang anliegenden Steuersignal abhängt. Vorzugsweise erzeugt die Stromquelle einen ausgehenden Gleichstrom, dessen Wert von dem Wert des Stroms bzw. der Spannung des an dem Steuereingang anliegenden Strom- bzw. Spannungssignals abhängt und durch diesen vorgegeben ist. Dabei kann ein hoher Pegel des steuernden Signals einem hohen Pegel des von der Stromquelle erzeugten Stromsignals und ein niedriger Pegel des steuernden Signals einem niedrigen Pegel des von der Stromquelle erzeugten Stromsignals entsprechen, d.h. die Stromquelle ist als nicht invertierende Stromquelle ausgebildet. Ebenso kann die Stromquelle als invertierende Stromquelle ausgebildet sein, d.h. ein hoher Pegel des steuernden Signals entspricht einem niedrigen Pegel des von der Stromquelle erzeugten Stromsignals und ein niedriger Pegel des steuernden Signals entspricht einem hohen Pegel des von der Stromquelle erzeugten Stromsignals. Ein hoher Pegel des von der Stromquelle erzeugten Stromsignals bedeutet dabei einen hohen positiven ausgehenden Stromfluss, z.B. 10 mA, und ein niedriger Pegel einen geringeren positiven ausgehenden Stromfluss, z. B. 0 mA.

Die gesteuerte Stromsenke kann als aktive Stromsenke, bevorzugt Gleichstromsenke, ausgebildet sein und dazu eingerichtet sein, an ihrem Ausgang aktiv einen, bezogen auf die technische Stromflussrichtung, positiven eingehenden, d.h. negativen ausgehenden, elektrischen Stromfluss zu erzeugen, der von dem an ihrem Steuereingang anliegenden Steuersignal abhängt. Vorzugsweise erzeugt die Stromsenke einen eingehenden Gleichstrom, dessen Wert von dem Wert des Stroms bzw. der Spannung des an dem Steuereingang anliegenden Strom- bzw. Spannungssignals abhängt und durch diesen vorgegeben ist. Dabei kann ein hoher Pegel des steuernden Signals einem hohen Pegel des von der Stromsenke erzeugten Stromsignals und ein niedriger Pegel des steuernden Signals einem niedrigen Pegel des von der Stromsenke erzeugten Stromsignals entsprechen, d.h. die Stromsenke ist als nicht invertierende Stromsenke ausgebildet. Ebenso kann die Stromsenke als invertierende Stromsenke ausgebildet sein, d.h. ein hoher Pegel des steuernden Signals entspricht einem niedrigen Pegel des von der Stromsenke erzeugten Stromsignals und ein niedriger Pegel des steuernden Signals entspricht einem hohen Pegel des von der Stromsenke erzeugten Stromsignals. Ein hoher Pegel des von der Stromsenke erzeugten Stromsignals bedeutet dabei einen hohen positiven eingehenden Stromfluss von z.B. 10 mA, und ein niedriger Pegel einen geringeren positiven eingehenden Stromfluss, z. B. 0 mA.

Durch die Verwendung derartiger Stromquellen bzw. Stromsenken kann die Leistungsaufnahme der Testschaltung auch im Fehlerfall wie z.B. einem Querschluss zwischen beiden Schaltpfaden gering gehalten werden.

Die Stromquelle und Stromsenke können, insbesondere in Bezug auf die von ihnen im fehlerfreien Betrieb gelieferten hohen und niedrigen Strompegel, so aufeinander abgestimmt sein, dass sich im Falle eines Querschlusses zwischen beiden Schaltpfaden an dem Stromrichtungselement eine Umkehrung der Stromrichtung ergibt oder zumindest eine deutliche Abweichung des Stromflusses von den bei fehlerfreiem Betrieb erwarteten Strompegeln, die zumindest für einen bestimmten Zeitraum anhält.

Die Stromquelle und Stromsenke können jeweils als spannungs- oder stromgesteuerte Stromquelle bzw. Stromsenke ausgebildet sein.

Vorzugsweise ist zumindest diejenige von Stromquelle oder Stromsenke, die mit dem Hinleiter des ersten Schaltpfads verbunden ist, so eingerichtet oder beschaltet, dass an ihrem gesteuerten Ausgang ein entgegen der Betriebsstromrichtung der Stromquelle bzw. -senke gerichteter Strom, d.h. ein eingehender Strom für die Stromquelle bzw. ein ausgehender Strom für die Stromsenke, vermieden wird. Die Stromquelle bzw. Stromsenke kann dabei selbst so ausgebildet sein, dass ein solcher Strom vermieden wird. Alternativ oder zusätzlich kann zwischen dem Ausgang der Stromquelle bzw. Stromsenke und dem Hinleiter des ersten Schaltpfads eine zusätzliches Bauelement angeordnet sein, welches einen solchen Strom verhindert, beispielsweise eine in Betriebsstromrichtung der Stromquelle bzw. -senke gepolte Diode oder ein ähnliches Sperrelement. Das Stromrichtungselement ist dazu eingerichtet, anhand des durch das Stromrichtungselement fließenden Stromes zu erkennen, wenn ein Querschluss zwischen den zwei Schaltpfaden vorliegt. Das Stromrichtungselement kann dazu erkennen, wenn an seinem Eingang ein von dem bei fehlerfreiem Betrieb des Sicherheitsteilnehmers erwarteten Stromfluss abweichender Stromfluss auftritt. Abhängig von der Einstellung der Stromquelle und Stromsenke bzw. deren jeweiligem hohen und niedrigen Strompegel, kann sich bei einem Querschluss zumindest zeitweise eine Umkehrung der Richtung des Stromflusses an dem Stromrichtungselement einstellen oder zumindest eine Abweichung des Werts des in der erwarteten Richtung fließenden Stroms von den bei fehlerfreiem Betrieb erwarteten Pegeln, zumindest für einen bestimmten Zeitraum. Eine solche Abweichung kann von dem Stromrichtungselement erkannt werden.

Gemäß einer vorteilhaften Ausführungsform ist das Stromrichtungselement dazu eingerichtet, zu erkennen, wenn an dem Stromrichtungselement ein Stromfluss mit einer der Erwartung bei fehlerfreiem Betrieb des Sicherheitsteilnehmers, d.h. in Abwesenheit eines Querschlusses zwischen beiden Schaltpfaden, entgegen gesetzten Richtung vorliegt. Wenn z.B. die Stromsenke mit dem zweiten Schaltpfad verbunden ist, um über diesen ein Stromsignal zu übertragen, wird an dem Stromrichtungselement ein positiver ausgehender Stromfluss erwartet. Umgekehrt wird bei einer alternativen Konfiguration, bei der die Stromquelle mit dem zweiten Schaltpfad verbunden ist, um über diesen ein Stromsignal zu übertragen, ein positiver eingehender Strom an dem Stromrichtungselement erwartet. Ein Querschluss kann dementsprechend von dem Stromrichtungselement anhand einer Umkehrung der Stromrichtung erkannt werden. Im Fall einer solchen Erkennung gibt das Stromrichtungselement vorzugsweise ein Signal aus, welches zu dem Ansprechen der Sicherheitsfunktion der Sicherheitssteuerung führt.

Das Stromrichtungselement kann auch dazu eingerichtet sein, zu erkennen, wenn an dem Stromrichtungselement zwar ein Stromfluss mit einer der Erwartung bei fehlerfreiem Betrieb des Sicherheitsteilnehmers entsprechenden Richtung vorliegt, dessen Wert sich aber zumindest für eine bestimmte Zeit von den bei fehlerfreiem Betrieb erwarteten Pegeln unterscheidet. Somit kann ein Querschluss zwischen beiden Schaltpfaden auch dann erkannt werden, wenn dieser nicht zu einer Umkehrung der Stromrichtung, sondern zu einem in der erwarteten Richtung gerichteten Strom mit einem, zumindest für eine bestimmte Zeit vorliegenden, unerwarteten Wert führt, z.B. einem Wert unterhalb des erwarteten hohen Pegels und oberhalb des erwarteten niedrigen Pegels. Vorzugsweise gibt das Stromrichtungselement in diesem Fall ein Signal aus, welches zu dem Ansprechen der Sicherheitsfunktion der Sicherheitssteuerung führt.

Gemäß einer vorteilhaften Ausführungsform ist das Stromrichtungselement dazu eingerichtet, bei dem Erkennen eines nicht fehlerfreien Betriebs, beispielsweise im Falle einer wie vorstehend beschriebenen Querschlusserkennung anhand eines in Bezug auf seine Richtung oder seinen Wert unerwarteten Stromsignals, ein Signal mit einem dauerhaft im Wesentlichen konstanten Pegel auszugeben. Ein solches Signal weist nicht die von der Sicherheitssteuerung erwartete Dynamik auf und führt somit zuverlässig zu einem Ansprechen der Sicherheitsfunktion der Sicherheitssteuerung.

Vorzugsweise entspricht das an dem Testsignalausgang des Sicherheitsteilnehmers bereitgestellte ausgehende Testsignal im fehlerfreien Betrieb des Sicherheitsteilnehmers und im geschlossenen Zustand beider Schaltpfade im Wesentlichen dem eingehenden Testsignal, d.h. zumindest in Bezug auf die von der Sicherheitssteuerung und deren Erwartungshaltung überprüften Eigenschaften, wie insbesondere Signalform und Signalsynchronität bzw. Timing.

Beispielsweise kann das Stromrichtungselement, solange der durch das Stromrichtungselement fließende Strom zwischen einem erwarteten niedrigen Pegel, z.B. 0 mA, und einem erwarteten hohen Pegel, z.B. 10 mA, wechselt, an seinem Ausgang ein Gleichstrom- oder bevorzugt Gleichspannungssignal erzeugen, welches dem an seinem Eingang empfangenen Stromsignal entspricht, d.h. dass ein hoher Strompegel des eingehenden Stromsignals mit einem hohen Strom- bzw. Spannungspegel des ausgehenden Signals des Stromrichtungselement korrespondiert und ein niedriger Strompegel des Stromsignals mit einem niedrigen Pegel des ausgehenden Stromsignals bzw. Spannungssignals des Stromrichtungselements korrespondiert. Das Stromrichtungselement ist vorzugsweise als elektrische Last oder passives elektrisches Element oder Bauteil ausgebildet.

Vorzugsweise ist die Testschaltung dazu eingerichtet, zwischen dem Rückleiter des ersten Schaltpfads und dem Steuereingang der mit dem Hinleiter des zweiten Schaltpfads verbundenen Stromquelle oder Stromsenke eine Signalinvertierung durchzuführen. Die Invertierung kann derart erfolgen, dass ein hoher Pegel des über den ersten Schaltpfad übertragenen Stromsignals mit einem niedrigen Pegel des über den zweiten Schaltpfad übertragenen Stromsignals korrespondiert und dass ein niedriger Pegel des über den ersten Schaltpfad übertragenen Stromsignals mit einem hohen Pegel des über den zweiten Schaltpfad übertragenen Stromsignals korrespondiert. Diese Invertierung bewirkt, dass in der Regel zu einem Zeitpunkt nur eine der Stromquelle und Stromsenke einen Strom mit einem hohen Pegel überträgt. Dadurch wird die Erkennung eines Querschlusses, insbesondere anhand einer Umkehrung der Stromrichtung, erleichtert.

Die vorstehend beschriebene Invertierung kann durch einen Invertierer durchgeführt werden, der zwischen dem Rückleiter des ersten Schaltpfads und dem Steuereingang der mit dem Hinleiter des zweiten Schaltpfads verbundenen Stromquelle bzw. Stromsenke angeordnet ist, insbesondere wenn die mit dem Hinleiter des zweiten Schaltpfads verbundene Stromquelle bzw. Stromsenke nicht-invertierend ist. Ebenso ist es möglich, dass die Invertierung durch die mit dem Hinleiter des zweiten Schaltpfads verbundene Stromquelle bzw. Stromsenke selbst durchgeführt wird, wenn diese als invertierende Stromquelle bzw. Stromsenke ausgebildet ist.

Die Testschaltung kann dazu eingerichtet sein, eine weitere Signalinvertierung durchzuführen. Dadurch kann gewährleistet werden, dass das an dem Testsignalausgang des Sicherheitsteilnehmers ausgehende Testsignal des Sicherheitsteilnehmers im fehlerfreien Betrieb des Sicherheitsteilnehmers und bei geschlossenen Schaltpfaden im Wesentlichen dem an dem Testsignaleingang eingehenden Testsignal entspricht. Beispielsweise kann die Testschaltung zwischen dem Testsignaleingang und dem Steuereingang der mit dem Testsignaleingang verbundenen Stromquelle oder Stromsenke eine Signalinvertierung durchführen. Diese Invertierung kann bedeuten, dass ein hoher Pegel des an dem Testsignaleingang eingehenden Testsignals mit einem niedrigen Pegel des über den ersten Schaltpfad übertragenen Stromsignals korrespondiert und dass ein niedriger Pegel des an dem Testsignaleingang eingehenden Testsignals mit einem hohen Pegel des über den ersten Schaltpfad übertragenen Stromsignals korrespondiert. Diese Invertierung kann z.B. von einem Invertierer durchgeführt werden, der zwischen dem Testsignaleingang und dem Steuereingang der mit dem Hinleiter des ersten Schaltpfads verbundenen Stromquelle bzw. Stromsenke angeordnet ist, insbesondere wenn die Stromquelle bzw. Stromsenke nicht-invertierend ausgebildet ist. Es kann aber auch eine invertierende Stromquelle bzw. Stromsenke verwendet werden, in welchem Fall auf einen separaten Invertierer verzichtet werden kann. Ebenso kann die Testschaltung eine Signalinvertierung zwischen dem Stromrichtungselement und dem Testsignalausgang durchführen.

Gemäß einer vorteilhaften Ausführungsform ist zwischen dem Rückleiter des ersten Schaltpfads und dem Steuereingang der mit dem Hinleiter des zweiten Schaltpfads verbundenen Stromquelle oder Stromsenke ein Stromflusselement der Testschaltung angeordnet, welches dazu ausgebildet ist, an seinem Eingang das über den Hinleiter des ersten Schaltpfads übertragene Stromsignal zu empfangen und an seinem Ausgang ein Gleichspannungssignal auszugeben, das von dem empfangenen Stromsignal abhängt. Das Stromflusselement kann dabei so eingerichtet sein, dass ein hoher Strompegel des eingehenden Stromsignals mit einem hohen Spannungspegel des ausgehenden Spannungssignals korrespondiert und ein niedriger Strompegel des eingehenden Stromsignals mit einem niedrigen Spannungspegel des ausgehenden Spannungssignals korrespondiert. Das Stromflusselement ist vorzugsweise als elektrische Last oder als passives elektrische Element oder Bauteil eingerichtet. Das ausgehende Spannungssignal des Stromflusselements kann zur Ansteuerung der mit dem Hinleiter des zweiten Schaltpfads verbundenen Stromquelle bzw. Stromsenke verwendet werden, wobei diese als spannungsgesteuerte Stromquelle bzw. Stromsenke ausgebildet ist. Es kann aber auch eine stromgesteuerte Stromquelle bzw. Stromsenke verwendet werden, die direkt, d.h. ohne Zwischenschaltung eines Stromflusselements, durch das über den ersten Schaltpfad übertragene Stromsignal angesteuert wird.

Gemäß einer vorteilhaften Ausführungsform ist zwischen dem Stromrichtungselement und dem Testsignalausgang eine Dynamikeinheit der Testschaltung angeordnet, die dazu eingerichtet ist, an ihrem Eingang das von dem Stromrichtungselement ausgegebene oder ein davon abgeleitetes Signal zu empfangen und ein Signal auszugeben, dessen Form davon abhängt, ob das empfangene Signal eine erwartete Dynamik aufweist. Bevorzugt ist die Dynamikeinheit dazu eingerichtet, das empfangene Signal im Wesentlichen unverändert weiterzuleiten, wenn das empfangene Signal die erwartete Dynamik aufweist. Wenn das empfangene Signal nicht die erwartete Dynamik aufweist, gibt die Dynamikeinheit vorzugsweise ein Signal mit einem im Wesentlichen konstanten Pegel aus, insbesondere mit einem konstanten hohen Pegel oder mit einem konstanten niedrigen Pegel. Die Dynamikeinheit kann dabei sowohl einen konstant hohen Pegel ihres Eingangssignals als auch einen konstant niedrigen Pegel ihres Eingangssignals auf denselben, bevorzugt entweder hohen oder niedrigen, Pegel ihres Ausgangssignals abbilden. Die einheitliche Abbildung sowohl eines konstant hohen Pegels als auch eines konstant niedrigen Pegels auf denselben Pegel führt zu einer Reduzierung der an dem Ausgang des Sicherheitsteilnehmers möglichen, zu einem Ansprechen der Sicherheitsfunktion führenden Zustände auf bevorzugt einen einzigen Zustand. Durch diese Zustandsreduktion wird es erleichtert, an der Sicherheitssteuerung anhand des eingehenden Testsignals einen Abschaltfall, d.h. das Vorliegen eines nicht sicheren Zustands eines Sicherheitsteilnehmers, von einem Systemfehler zu unterscheiden.

Die Testschaltung des Anschaltungsmoduls kann zumindest teilweise und vorzugsweise vollständig aus diskreten Bauteilen aufgebaut sein, wobei bevorzugt zumindest die Stromquelle, die Stromsenke und das Stromrichtungselement durch getrennte diskrete Bauteile gebildet sind. Die Testschaltung kann somit ohne integrierte Schaltkreise realisiert werden. Vorzugsweise weist die Testschaltung keine von dem Testsignal unabhängige, eigene Zeitbasis auf. Im Rahmen der Testschaltung kann somit vollständig auf durch eine eigene Zeitbasis getaktete Bauteile wie z.B. getaktete Mikroprozessoren verzichtet werden. Stattdessen wird die Dynamik der durch die Testschaltung erzeugten Signale vorzugsweise allein durch die Dynamik des eingehenden Testsignals erzeugt, insbesondere indem das eingehende Testsignal die gesteuerte Stromquelle und Stromsenke ansteuert. Durch den Verzicht auf integrierte Schaltkreise und/oder mit einer eigenen Zeitbasis getaktete elektrische oder elektronische Elemente wird die Zuverlässigkeit der Testschaltung deutlich erhöht, da mit der Verwendung der vorstehenden Elemente zusammenhängende Funktionsfehler ausgeschlossen sind. Außerdem wird die mit der Verwendung derartiger Elemente einhergehende zeitliche Verzögerung des Testsignals vermieden, so dass das ausgehende Testsignal des Sicherheitsteilnehmers gegenüber dem entsprechenden eingehenden Testsignal im Wesentlichen unverzögert ausgegeben werden kann, wodurch eine geringe Ansprechzeit des Sicherheitssystems gewährleistet wird.

Das Schutzgerät und das Anschaltungsmodul des Sicherheitsteilnehmers sind bevorzugt örtlich getrennt angeordnet und umfassen jeweils ein eigenes Gehäuse, wobei ein Gehäuse vorzugsweise nach der Gehäuseschutzart IP 67 oder IP 20 oder einer sonstigen gegen Schmutz oder Feuchtigkeit schützenden Gehäuseschutzart ausgebildet ist. Die Anschaltungsleitung ist vorzugsweise durch ein gemeinsames, die Hinleiter und Rückleiter beider Schaltpfade enthaltendes Anschaltungskabel gebildet. Die Busleitung ist vorzugsweise durch eines oder mehrere Buskabel gebildet, die die Sicherheitssteuerung mit dem Anschaltungsmodul verbinden, wobei die Sicherheitssteuerung vorzugsweise örtlich von dem Sicherheitsteilnehmer getrennt in einem Schaltschrank angeordnet ist.

Umfasst das Sicherheitssystem mehrere Sicherheitsteilnehmer, sind diese vorzugsweise über die zu überwachende Anlage oder Maschine verteilt angeordnet und über Buskabel der Busleitung miteinander verbunden. Das Sicherheitssystem kann als Feldbussystem ausgebildet sein, d.h. dass die Komponenten des Sicherheitssystems, insbesondere mehrere Sicherheitsteilnehmer des Bussystems, örtlich verteilt angeordnet sind. Der Abstand zwischen zwei verschiedenen Sicherheitsteilnehmern oder zwischen einem Sicherheitsteilnehmer und der Sicherheitssteuerung kann dabei erheblich sein und z.B. einen oder mehrere Meter betragen. Ein Anschaltungskabel oder Buskabel verläuft vorzugsweise außerhalb der Gehäuse und ist vorzugsweise als gegen Schmutz oder Feuchtigkeit schützendes, für die Verlegung außerhalb von Gehäusen geeignetes und zulässiges Standard-Sensor/Aktor-Kabel, beispielsweise vom Typ M 12, mit einem Leiter- bzw. Aderquerschnitt von vorzugsweise mindestens 0,34 mm² ausgebildet. Die Verbindungen zwischen den Kabeln bzw. Anschaltungskabeln und der Sicherheitssteuerung, dem Anschaltungsmodul und dem Schutzgerät sind vorzugsweise durch Steckverbindungen, z.B. vom Typ M 12, realisiert. Den Abständen zwischen den Sicherheitsteilnehmern entsprechend kann ein Buskabel eine Länge von z.B. einem oder mehreren Metern aufweisen.

Ein Schalter des Schutzgeräts ist vorzugsweise als mechanischer elektrischer Schaltkontakt ausgebildet, welcher beispielsweise mechanisch betätigbar sein kann, beispielsweise ein mechanisch betätigbarer Schaltkontakt eines als Not-Aus-Taster ausgebildeten Schutzgeräts, oder welcher elektrisch betätigbar sein kann, wie z.B. der Schaltkontakt eines Sicherheitsrelais. Der Schaltkontakt kann auch magnetisch betätigbar sein, wie z.B. der Schaltkontakt eines Reed-Schalters, welcher beispielsweise bei einem als Türzuhaltung ausgebildeten Schutzgerät eingesetzt werden kann und welcher durch Schließen und Öffnen der Tür schließbar und unterbrechbar ist. Bei dem Schutzgerät handelt es sich vorzugsweise um ein Sicherheitsschaltgerät mit zwei äquivalent öffnenden elektrischen Schaltern, die jeweils durch einen wie vorstehend beschriebenen Schaltkontakt gebildet sein können, wobei beide Schalter im sicheren Zustand des Schutzgeräts geschlossen und im nicht sicheren Zustand geöffnet sind. Vorzugsweise sind die beiden Schalter des Schutzgeräts dazu eingerichtet, bei einem Wechsel von dem sicheren in den nicht sicheren Zustand und umgekehrt im Wesentlichen gleichzeitig zu schalten.

Wie vorstehend beschrieben, ist das Schutzgerät vorzugsweise dazu ausgebildet ist, die beiden Schalter bei dem Eintreten eines nicht sicheren Zustands des Schutzgeräts gemeinsam zu öffnen und dadurch den zugehörigen elektrischen Schaltpfad zu unterbrechen. Gemäß einer Ausführungsform, die im Zusammenhang mit der Figurenbeschreibung eingehend erläutert ist, umfasst der Sicherheitsteilnehmer einen in dem Testsignalpfad angeordneten Unterbrechungsschalter und eine Auswerteeinheit, die vorzugsweise Teil des Anschaltungsmoduls ist, die mit dem ersten und zweiten Schaltpfad verbunden ist und die dazu eingerichtet ist, zu überprüfen, ob die ersten und zweiten Schaltpfade gemeinsam unterbrochen werden, und um den Unterbrechungsschalter zu öffnen, wenn die zwei Schaltpfade nicht gemeinsam unterbrochen werden.

Dadurch kann an dem Sicherheitsteilnehmer lokal erkannt werden, wenn die gewünschte gemeinsame Schaltbarkeit der beiden Schaltpfade nicht mehr gewährleistet ist, sondern eine Diskrepanz der beiden Schaltpfade und somit eine Fehlfunktion des Sicherheitsteilnehmers vorliegt. Eine solche Fehlfunktion, die auch als Diskrepanzfehler bezeichnet wird, kann beispielsweise durch ein Festschweißen eines der Schaltkontakte des Schutzgeräts bedingt sein, das ein ordnungsgemäßes Öffnen des Schaltkontakts bei dem Eintreten eines nicht sicheren Zustands des Schutzgeräts verhindert. Die Überprüfung durch die lokale Auswerteeinheit stellt eine wichtige zusätzliche Schutzfunktion dar. Zwar wird auch bei ordnungsgemäßem Auslösen nur eines Schutzkanals, d.h. bei einem Öffnen nur eines Schalters, infolge der in der Testschaltung realisierten Serienschaltung der zwei Schalter eine Unterbrechung des Testsignalpfads und damit eine Sicherheitsabschaltung bewirkt, jedoch geht die durch das Vorsehen der zwei Schaltpfade bezweckte Redundanz und die damit einhergehende erhöhte Sicherheit verloren. Die Fehlererkennung durch die Auswerteeinheit verhindert jedoch, dass ein Erstfehler in Form einer solchen Fehlfunktion eines Schalters unerkannt bleibt und toleriert wird und dadurch die Möglichkeit einer Fehlerhäufung dergestalt geschaffen würde, dass eine Fehlfunktion des anderen Schalters zu einem vollständigen Verlust der sichernden Funktion des Sicherheitsteilnehmers führt.

Die Auswerteeinheit kann auch dazu dienen, einen Leitungsfehler wie insbesondere einen Kurzschluss oder Querschluss zu erkennen, der zwischen den Hin- und Rückleitem der wenigstens zwei Schaltpfade auftreten kann, welche die Schalter des Schutzgeräts mit dem Anschaltungsmodul verbinden, in welchem vorzugsweise die Auswerteeinheit aufgenommen ist.

Um den Schaltzustand der elektrischen Schaltpfade zu überprüfen, kann die Auswerteeinheit z.B. jeweils mit dem Hinleiter und mit dem Rückleiter verbunden sein, zwischen denen der jeweilige Schalter in Serie geschaltet ist. In diesem Fall kann die Auswerteeinheit auch einen Leitungsfehler erkennen wie insbesondere einen Kurzschluss oder einen Querschluss zwischen den Hinleitem und Rückleitern. Beispielsweise kann ein Kurzschluss zwischen dem Hinleiter und dem Rückleiter eines Schaltpfads oder auch ein Querschluss zwischen dem Hinleiter oder Rückleiter eines Schaltpfads und dem Hinleiter oder Rückleiter des anderen Schaltpfads aus der Sicht der Auswerteeinheit jeweils wie ein dauerhaft geschlossener erster bzw. zweiter Schalter bzw. Schaltkontakt erscheinen und deshalb z.B. ähnlich wie ein festgeschweißter Schaltkontakt zu einem Diskrepanzfehler führen, so dass die Auswerteeinheit auch einen solchen Fehler erkennen kann. Dadurch wird die Sicherheit des Systems noch weiter erhöht.

Wenn der Sicherheitsteilnehmer bzw. das Schutzgerät zusätzlich zu dem ersten und zweiten Schalter noch einen oder mehrere weitere Schalter bzw. Schaltpfade aufweist, die bei dem Eintreten eines nicht sicheren Zustands des Schutzgeräts gemeinsam mit dem ersten und zweiten Schaltpfad unterbrechbar sind, überprüft die Auswerteeinheit vorzugsweise, ob alle gemeinsam unterbrechbaren Schaltpfade des Sicherheitsteilnehmers gemeinsam unterbrochen werden, und öffnet andernfalls den Unterbrechungsschalter.

Gemäß einer vorteilhaften Ausführungsform ist die Auswerteeinheit dazu ausgebildet, zu überprüfen, ob die zwei Schaltpfade des Sicherheitsteilnehmers zumindest bis auf eine vorgegebene Diskrepanzzeit gleichzeitig unterbrochen werden. Ebenso kann die Auswerteeinheit dazu ausgebildet sein, zu überprüfen, ob die zwei Schaltpfade bis auf eine vorgegebene Diskrepanzzeit gleichzeitig geschlossen werden, beispielsweise bei einem Einschalten oder Wiedereinschalten des Sicherheitssystems. Eine solche Einschaltüberwachung kann getrennt von der Überwachung des gemeinsamen Unterbrechens der Schaltpfade realisiert sein. Um die Gleichzeitigkeit des Unterbrechens bzw. die Gleichzeitigkeit des Schließens zu überwachen, kann die Auswerteeinheit beispielsweise einen entsprechend eingerichteten Mikroprozessor und/oder eine eigene Zeitbasis wie z.B. einen Taktgeber des Mikroprozessors umfassen.

Gemäß einer weiteren Ausführungsform der Erfindung, die ebenfalls im Zusammenhang mit der Figurenbeschreibung ausführlich erläutert ist, umfasst das Sicherheitssystem wenigstens einen weiteren an die Busleitung angeschlossenen und ein Schutzgerät umfassenden Sicherheitsteilnehmer, der derart eingerichtet sind, dass das Vorliegen eines nicht sicheren Zustands seines Schutzgeräts eine Unterbrechung des Testsignalpfads bewirkt. Beide Sicherheitsteilnehmer können dabei als zweikanalige Sicherheitsschaltgeräte mit einer wie vorstehend beschriebenen Testschaltung ausgebildet sein. Mehrere und vorzugsweise alle Sicherheitsteilnehmer des Systems sind entlang der Busleitung so in einer Linie angeordnet sind, dass sowohl der Hinleitungspfad als auch der Rückleitungspfad des Testsignalpfads durch dieselben Sicherheitsteilnehmer hindurch verlaufen. Das Sicherheitssystem weist zudem ein vorzugsweise an dem Ende der Linie angeschlossenes, den Hinleitungspfad und den Rückleitungspfad des Testsignalpfads verbindendes Abschlusselement auf. Die Sicherheitssteuerung ist dazu ausgebildet ist, an ihrem mit dem Hinleitungspfad verbundenen Ausgang ein Ausgangssignal bzw. Testsignal auszusenden. Das Abschlusselement ist dazu ausgebildet, das Ausgangssignal von dem Hinleitungspfad zu empfangen und in Abhängigkeit von dem von dem Hinleitungspfad empfangenen Ausgangssignal ein gegenüber dem empfangenen Ausgangssignal verändertes Testsignal an den Rückleitungspfad des Testsignalpfads auszugeben.

Bei dieser Ausgestaltung laufen also der Hinleitungspfad und der Rückleitungspfad des Testsignalpfads durch dieselben Sicherheitsteilnehmer hindurch. Der Testsignaleingang und der Testsignalausgang des jeweiligen Sicherheitsteilnehmers mit der dazwischen angeordneten Testschaltung des Sicherheitsteilnehmers sind dabei vorzugsweise in den Rückleitungspfad des Testsignalpfads eingebunden. Der Hinleitungspfad des Testsignalpfads wird vorzugsweise einfach ohne Unterbrechungsmöglichkeit durch den Sicherheitsteilnehmer durchgeschleift.

Dadurch, dass sowohl der Hinleitungspfad als auch der Rückleitungspfad des Testsignalpfads durch dieselben Sicherheitsteilnehmer hindurch verlaufen, wird eine Linientopologie der Busleitung und der an die Busleitung angeschlossenen Sicherheitsteilnehmer realisiert. Der erforderliche Verkabelungsaufwand wird dadurch gegenüber einer Ringtopologie der Busleitung noch weiter reduziert, weil es nicht erforderlich ist, den Hinleitungspfad und den Rückleitungspfad des Testsignalpfads in getrennten Kabeln zu führen. Stattdessen können diese zumindest abschnittsweise in gemeinsamen Kabeln von einem Sicherheitsteilnehmer zum nächsten geführt werden. Das an dem Ende der Linie angeordnete Abschlusselement und die durch das Abschlusselement durchgeführte Veränderung bzw. Umwandlung des von dem Hinleitungspfad empfangenen Ausgangssignals in ein an den Rückleitungsfad ausgegebenes Testsignal dient dabei dazu, einen Querschluss zwischen dem Hinleitungspfad und dem Rückleitungspfad des Testsignalpfads zu erkennen. Die Erwartungshaltung, auf die die Sicherheitssteuerung das an dem Sicherheitseingang empfangene Testsignal überprüft, ist dabei vorzugsweise so ausgebildet, dass das Erfüllen der Erwartungshaltung die durch das Abschlusselement durchgeführte Signalveränderung bzw. -umwandlung voraussetzt und eine Überbrückung des Abschlusselements infolge eines Querschlusses zwischen dem Hinleitungspfad und dem Rückleitungspfad des Testsignalpfads zu einer Verletzung der Erwartungshaltung und somit zu einem Ansprechen der Sicherheitsfunktion führt, beispielsweise wenn infolge eines Querschlusses ein gegenüber dem ausgesendeten Ausgangssignal unverändertes eingehendes Testsignal empfangen wird. Somit wird trotz der Linientopologie und der dabei bestehenden Möglichkeit eines Querschlusses zwischen Hinleitungspfad und Rückleitungspfad des Testsignalpfads ein hohes Sicherheitsniveau bei geringem Verkabelungsaufwand erreicht.

Das Sicherheitssystem und dessen hierein beschriebene Sicherheitsfunktion erfüllen vorzugsweise den Sicherheitslevel SIL 3 gemäß der Norm IEC 61508 und/oder den Sicherheitslevel Performance Level e ("PL e") gemäß der Norm EN ISO 13849-1. Der Sicherheitseingang der Sicherheitssteuerung umfasst bevorzugt einen sicheren Eingang. Der sichere Eingang zeichnet sich durch eine fehlersichere Auswertung des eingehenden Signals in der Sicherheitssteuerung aus, wozu zum Beispiel eine zweikanalige Auswertung erfolgen kann, die z.B. durch zwei parallel arbeitende redundante und einander kontrollierende Mikroprozessoren durchgeführt wird.

Nachfolgend wird die Erfindung beispielhaft anhand einer vorteilhaften Ausführungsform unter Bezugnahme auf die beigefügten Figuren beschrieben. Es zeigen:
- Fig. 1: ein Sicherheitssystem gemäß einer Ausführungsform der Erfindung in schematischer Darstellung,
- Fig. 2: einen Sicherheitsteilnehmer eines Sicherheitssystems gemäß einer Ausführungsform der Erfindung,
- Fig. 3: beispielhafte, durch die Testschaltung des Sicherheitsteilnehmers von Fig. 2 übertragene Strom- und Spannungssignale,
- Fig. 4: einen weiteren möglichen Sicherheitsteilnehmer eines Sicherheitssystems gemäß einer Ausführungsform der Erfindung, und
- Fig. 5: ein Sicherheitssystem gemäß einer weiteren Ausführungsform der Erfindung.

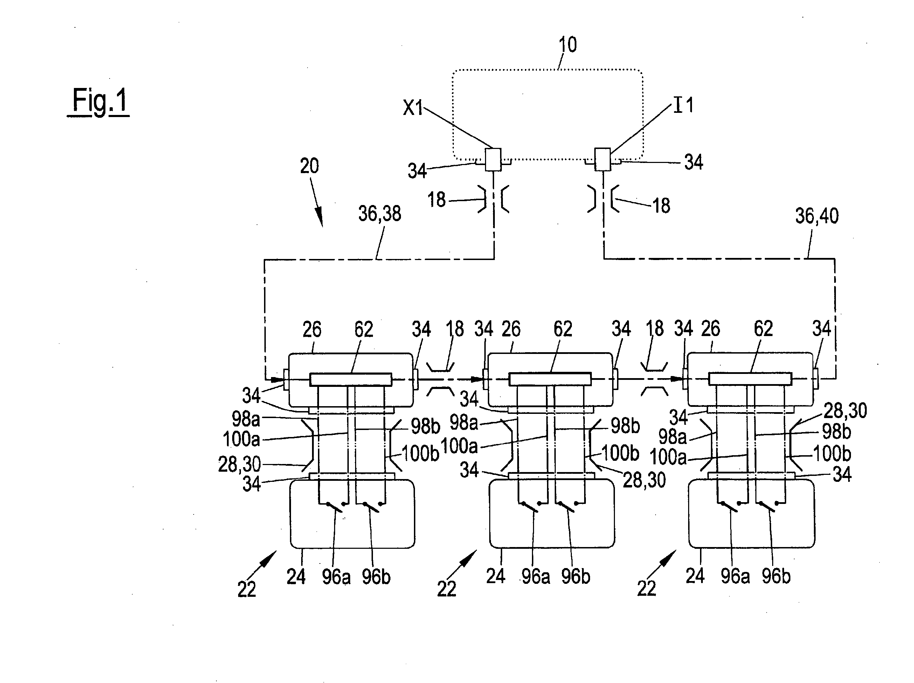

Fig. 1 zeigt ein Sicherheitssystem gemäß einer Ausführungsform der Erfindung. Das Sicherheitssystem umfasst eine Sicherheitssteuerung 10, die in einem Schaltschrank angeordnet sein kann und einen Ausgang X1 sowie einen Sicherheitseingang I1 umfasst.

Das Sicherheitssystem umfasst eine Busleitung 18 mit mehreren Buskabeln 20, wobei eines der Buskabel 20 an den Ausgang X1 und eines der Buskabel 20 an den Eingang I1 der Sicherheitssteuerung 10 angeschlossen ist. Das Sicherheitssystem umfasst ferner mehrere Sicherheitsteilnehmer 22, die über die Buskabel 20 der Busleitung 18 mit der Sicherheitssteuerung 10 verbunden sind. Die Sicherheitsteilnehmer 22 umfassen jeweils ein Schutzgerät 24 und ein Anschaltungsmodul 26, welches über eine durch ein Anschaltungskabel 28 gebildete Anschaltungsleitung 30 mit dem jeweiligen Schutzgerät 24 verbunden ist und welches direkt mit den jeweils benachbarten Buskabeln 20 verbunden ist. Die Schutzgeräte 24 sind somit über einzelne, jeweils eine Stichleitung bildende Anschaltungskabel 28 an die Busleitung 18 angeschlossen.

Die Verbindungen der Sicherheitssteuerung 10, der Schutzgeräte 24 und der Anschaltungsmodule 26 mit den Kabeln 20 und den Anschaltungskabeln 28 sind jeweils durch eine beispielsweise aus einem Steckverbinder wie etwa vom Typ M 12 des einen Elements und einer entsprechenden Steckerbuchse des anderen Elements bestehende elektrische Steckverbindung 34 gebildet.

Ein Kabel ist in den Figuren prinzipiell jeweils durch zwei aufeinander zu gewandte Kammern dargestellt, die den Mantel des Kabels repräsentieren, wobei in der Regel eine der Klammern mit dem entsprechenden Bezugszeichen versehen ist, d.h. dem Bezugszeichen 20 für ein Buskabel bzw. dem Bezugszeichen 28 für ein Anschaltungskabel. Die zwischen den Klammern eines Kabels jeweils eingezeichneten ein oder mehreren Linien repräsentieren jeweils eine in dem jeweiligen Kabel angeordnete elektrische Leitung, welche aus einem oder mehreren in dem Kabelmantel angeordneten elektrischen Leitungsadern bestehen kann.

Die Busleitung 18 bzw. jeweilige Adern der Buskabel 20 der Busleitung 18 und die an die Busleitung 18 angeschlossenen Sicherheitsteilnehmer 22 bilden einen einkanaligen, ringförmigen Testsignalpfad 36 mit einem mit dem Ausgang X1 der Sicherheitssteuerung 10 verbundenen Hinleitungspfad 38 und einem mit dem Sicherheitseingang I1 der Sicherheitssteuerung 10 verbundenen Rückleitungspfad 40.

Die Schutzgeräte 24 der Sicherheitsteilnehmer 22 sind als zweikanalige Sicherheitsschaltgeräte ausgebildet, die jeweils zwei äquivalent schaltende und bei dem Eintreten des nicht sicheren Zustands des Schutzgeräts 24 gemeinsam unterbrechbare bzw. öffnende elektrische Schalter 96a, 96b umfassen, die jeweils einen Schutzkanal des Schutzgeräts 24 bilden. Konkret kann es sich bei einem Schutzgerät 24 beispielsweise um einen zweikanaligen Not-Aus-Taster handeln, dessen Schalter 96a, 96b im sicheren, d.h. nicht betätigten, Zustand des Not-Aus-Tasters geschlossen sind und dessen Schalter 96a, 96b im nicht sicheren, d.h. betätigten, Zustand des Not-Aus-Tasters geöffnet sind. Ebenso kann es sich um eine Zuhaltung einer Sicherheitstür handeln, wobei die Schalter 96a, 96b im sicheren Zustand, d.h. bei geschlossener Sicherheitstür, geschlossen sind und die Schalter 96a, 96b im nicht sicheren Zustand, d.h. bei geöffneter Sicherheitstür, geöffnet sind. Die Schalter 96a, 96b sind jeweils über einen Hinleiter 98a bzw. 98b und einen Rückleiter 100a bzw. 100b des Anschaltungskabels 28 mit dem Anschaltungsmodul 26 verbunden, wobei jeder Schalter 96a, 96b mit dem zugehörigen Hin- und Rückleiter 98a, 98b, 100a, 100b jeweils einen elektrischen Schaltpfad des Sicherheitsteilnehmers 22 bildet. Diese unterbrechbaren Schaltpfade mit den Schaltern 96a, 96b sind über eine in dem Anschaltungsmodul 26 angeordnete, in Fig. 1 nur schematisch dargestellte Testschaltung 62 in den Testsignalpfad 36 seriell eingebunden und miteinander elektrisch in Serie geschaltet.

Im Betrieb des in Fig. 1 gezeigten Sicherheitssystems erzeugt die Sicherheitssteuerung 10 ein Ausgangs- bzw. Testsignal und sendet dieses über den Ausgang X1 an den Hinleitungspfad 38 des Testsignalpfads 36 aus. Dieses Ausgangs- bzw. Testsignal ist ein dynamisches, d.h. zeitveränderliches, Signal. Vorliegend ist das Signal ein binärwertiges Signal, beispielsweise ein binärwertiges, auf elektrischer Spannung basiertes Signal, welches zwischen einem hohen Spannungspegel von beispielsweise 24 Volt und einem niedrigen Spannungspegel von beispielsweise 0 Volt oder Massepotential wechselt. Das Ausgangssignal kann z.B. mit einer vorgegebenen Zykluszeit periodisch auftretende Testlücken mit einer vorgegebenen Dauer aufweisen, wobei das Signal während der Testlücken jeweils dauerhaft den niedrigen Signalpegel aufweist und zwischen zwei aufeinander folgenden Testlücken dauerhaft den hohen Signalpegel aufweist.

Die Sicherheitssteuerung 10 ist dazu ausgebildet, das an ihrem Sicherheitseingang I1 eingehende Testsignal zu empfangen und mit einer in der Sicherheitssteuerung 10 konfigurierten Erwartungshaltung zu vergleichen und um im Falle einer Verletzung der Erwartungshaltung eine Sicherheitsabschaltung der durch die Sicherheitsteilnehmer 22 überwachten Anlage einzuleiten. Im vorliegenden Ausführungsbeispiel erwartet die Sicherheitssteuerung 10 ein gegenüber dem von der Sicherheitssteuerung 10 an dem Ausgang X1 ausgesendeten Ausgangssignal im Wesentlichen unverändertes, an dem Sicherheitseingang I1 eingehendes Testsignal. Die Sicherheitssteuerung 10 kann dabei das eingehende Signal z.B. auf Synchronität zu dem ausgesendeten Signal überprüfen, insbesondere auf das zu dem ausgesendeten Signal synchrone Auftreten von Testlücken der erwarteten Dauer.

In dem sicheren Zustand aller Schutzgeräte 24 und im fehlerfreien Zustand des Sicherheitssystems sind die Schalter 96a, 96b der Schutzgeräte 24 geschlossen. Die Testschaltung 62 jedes Sicherheitsteilnehmers 22 ist dazu eingerichtet, in diesem Zustand das eingehende Testsignal zu empfangen und ein gegenüber dem eingehenden Testsignal im Wesentlichen unverändertes ausgehendes Testsignal auszugeben, so dass die Erwartungshaltung der Sicherheitssteuerung 10 erfüllt wird. Die Testschaltung 62 ist ferner dazu eingerichtet, das Testsignal zu unterbrechen bzw. ein Testsignal auszugeben, welches zu einer Verletzung der Erwartungshaltung der Sicherheitssteuerung 10 und somit zu einem Ansprechen der Sicherheitsfunktion führt, wenn zumindest einer der Schaltpfade 96a, 96b des Schutzgeräts 24 unterbrochen ist. Die Testschaltung 62 ist außerdem dazu eingerichtet, das Testsignal auch dann zu unterbrechen bzw. ein Testsignal auszugeben, welches zu einer Verletzung der Erwartungshaltung der Sicherheitssteuerung 10 und somit zu einem Ansprechen der Sicherheitsfunktion führt, wenn ein Querschluss zwischen den beiden elektrischen Schaltpfaden besteht, d.h. wenn der Hinleiter 98a oder Rückleiter 100a des einen Schaltpfads einen Querschluss zu dem Hinleiter 98b oder Rückleiter 100b des anderen Schaltpfads aufweist. Somit führt auch dieser Fehlerfall zu einem Ansprechen der Sicherheitsfunktion, so dass eine Tolerierung eines solchen Querschlusses und eine damit einhergehende Beeinträchtigung der Sicherheit ausgeschlossen ist. Um ein Ansprechen der Sicherheitsfunktion zu verursachen, kann die Testschaltung 62 an ihrem Ausgang beispielsweise dauerhaft einen konstanten Signalpegel anlegen, z.B. einen dauerhaft hohen Signalpegel von 24 Volt oder einen dauerhaft niedrigen Signalpegel von z.B. 0 Volt. Die entsprechende fehlende Dynamik bzw. die fehlenden Testlücken des ausgehenden Testsignals führen zu dem Ansprechen der Sicherheitsfunktion.

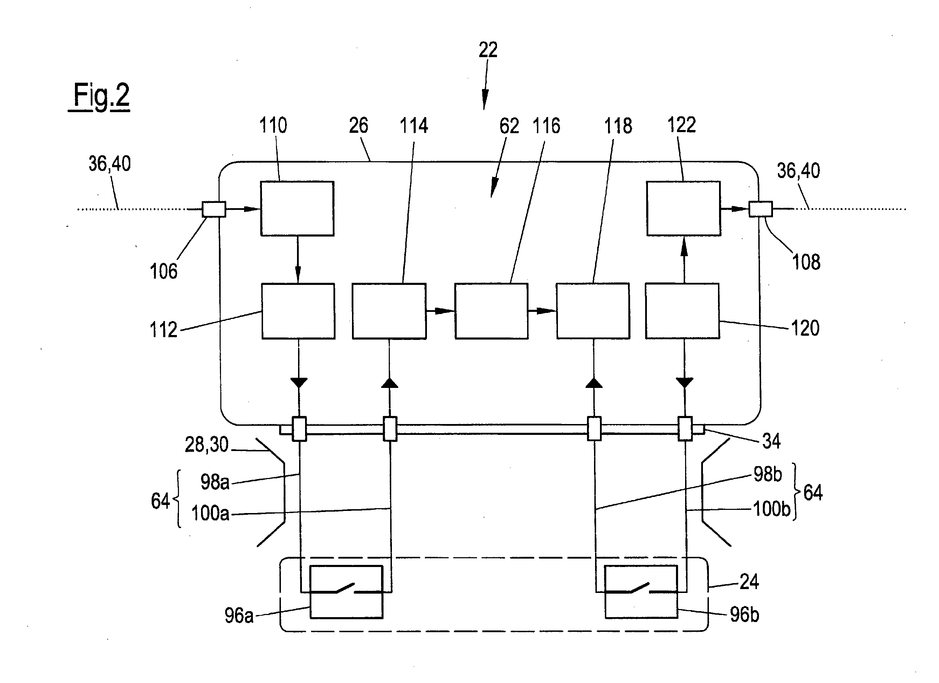

Fig. 2 zeigt einen wie in Fig. 1 gezeigten Sicherheitsteilnehmer 22 einschließlich Details der in dem Anschaltungsmodul 26 des Sicherheitsteilnehmers 22 angeordneten Testschaltung 62. Das Bezugszeichen 64 in Fig. 2 bezeichnet die durch ein Paar aus Hinleiter 98a, 98b und Rückleiter 100a, 100b der Anschaltungsleitung 30 gebildete Verbindung zwischen dem Anschaltungsmodul 26 und einem Kanal des Schutzgeräts 24.

An dem Testsignaleingang 106 des Anschaltungsmoduls 26 wird das von dem Ausgang X1 der Sicherheitssteuerung 10 ausgegebene und über den Testsignalpfad 36 übertragene dynamische Testsignal empfangen. Wie vorstehend beschrieben, handelt es sich bevorzugt um ein spannungsbasiertes Signal, insbesondere ein binärwertiges Gleichspannungssignal, welches in periodischen Abständen Testlücken einer vorgegebenen konstanten Dauer aufweist, während derer das Testsignal dauerhaft einen niedrigen Spannungspegel aufweist und zwischen denen das Testsignal dauerhaft einen hohen Spannungspegel aufweist.

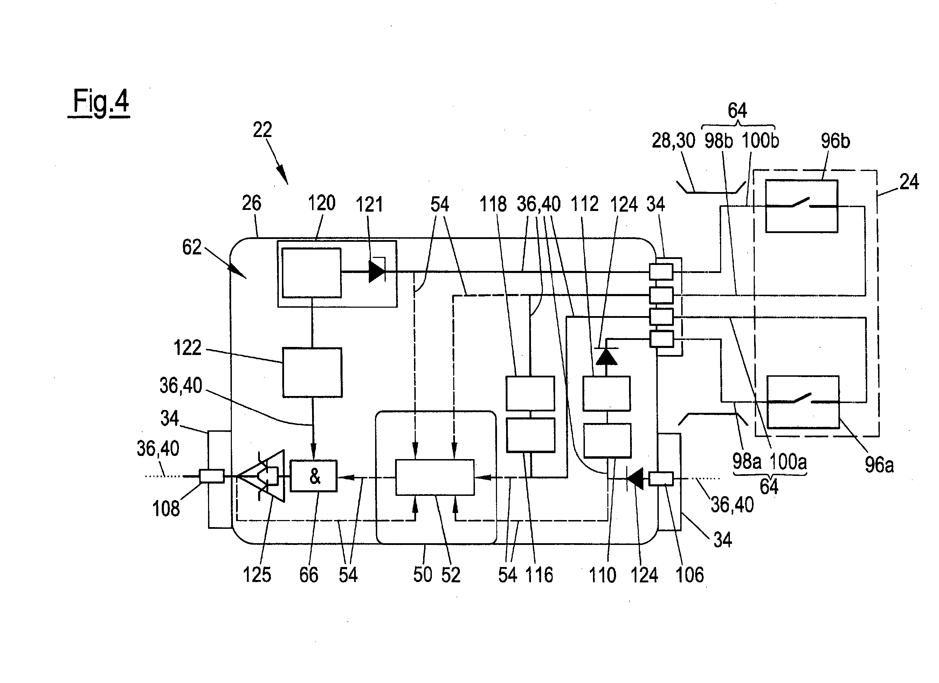

Der Testsignaleingang 106 ist mit dem Eingang eines Invertierers 110 verbunden, der das eingehende Testsignal empfängt und invertiert und an seinem Ausgang ein invertiertes, bevorzugt ebenfalls spannungsbasiertes Testsignal ausgibt. Zwischen dem Testsignaleingang 106 und dem Eingang des Invertierers 110 kann, wie in der nachstehend noch im Einzelnen erläuterten Fig. 4 gezeigt, eine Diode 124 angeordnet sein, die in positiver Signalflussrichtung des Testsignals gepolt ist und einen positiven ausgehenden Stromfluss von dem Sicherheitsteilnehmer 22 zu dem vorhergehenden Abschnitt des Testsignalpfads 36 verhindert. Diese Diode 124 ist aber nicht unbedingt erforderlich.

Der Ausgang des Invertierers 110 ist mit dem Steuereingang der gesteuerten Stromquelle 112 verbunden, die dazu ausgebildet ist, das von dem Invertierer 110 gelieferte Gleichspannungssignal in ein Gleichstromsignal umzuwandeln, derart, dass ein hoher Pegel des von dem Invertierer 110 gelieferten Gleichspannungssignal mit einem hohen Pegel des Gleichstromsignals korrespondiert und ein niedriger Pegel des von dem Invertierer 110 gelieferten Gleichspannungssignal mit einem niedrigen Pegel des Gleichstromsignals korrespondiert. Die gesteuerte Stromquelle 112 ist als aktive Stromquelle ausgebildet und dazu eingerichtet, an ihrem Ausgang aktiv einen, bezogen auf die technische Stromflussrichtung, positiven ausgehenden elektrischen Stromfluss zu erzeugen, der wie vorstehend beschrieben von dem anliegenden Steuersignal abhängt. Zwischen dem Ausgang der gesteuerten Stromquelle 112 und dem Hinleiter 98a ist, wie in Fig. 4 gezeigt, eine in der Richtung des ausgehenden Stroms der Stromquelle 112 gepolte Diode 124 angeordnet, die einen in die Stromquelle 112 eingehenden Stromfluss verhindert.

Das von der gesteuerten Stromquelle 112 erzeugte Stromsignal wird über den ersten elektrischen Schaltpfad, d.h. über den Hinleiter 98a, den im sicheren Zustand des Schutzgeräts 24 geschlossenen Schalter 96a und den Rückleiter 100a, zu einem Stromflusselement 114 der Testschaltung 62 übertragen. Das Stromflusselement 114 ist dazu ausgebildet, an seinem Eingang das über den Rückleiter 100a übertragene Stromsignal zu empfangen und an seinem Ausgang ein Gleichspannungssignal auszugeben, derart, dass ein hoher Strompegel des eingehenden Stromsignals mit einem hohen Spannungspegel des ausgehenden Spannungssignals korrespondiert und ein niedriger Strompegel des eingehenden Stromsignals mit einem niedrigen Spannungspegel des ausgehenden Spannungssignals korrespondiert.

Das von dem Stromflusselement 114 erzeugte Spannungssignal wird an einen zweiten Invertierer 116 übertragen, der das Signal empfängt und invertiert und an seinem Ausgang ein invertiertes Signal ausgibt, wobei bei der Invertierung ein hoher Signal- bzw. Spannungspegel des eingehenden Signals in einen niedrigen Signal- bzw. Spannungspegel des ausgehenden Signals umgewandelt wird und ein niedriger Signal- bzw. Spannungspegel des eingehenden Signals in einen hohen Signal- bzw. Spannungspegel des ausgehenden Signals umgewandelt wird.

Der Ausgang des Invertierers 116 ist mit dem Steuereingang einer gesteuersten Stromsenke 118 verbunden, die dazu ausgebildet ist, das von dem Invertierer 116 gelieferte Gleichspannungssignal in ein Gleichstromsignal umzuwandeln, derart, dass ein hoher Pegel des von dem Invertierer 116 gelieferten Gleichspannungssignals mit einem hohen Pegel des Gleichstromsignals korrespondiert und ein niedriger Pegel des von dem Invertierer 116 gelieferten Gleichspannungssignals mit einem niedrigen Pegel des Gleichstromsignals korrespondiert. Die gesteuerte Stromsenke 118 ist als aktive Stromsenke ausgebildet und dazu eingerichtet, an ihrem Ausgang einen, bezogen auf die technische Stromrichtung, positiven eingehenden, d.h. negativen ausgehenden, elektrischen Stromfluss zu erzeugen, der in der vorstehend beschriebenen Weise von dem anliegenden Steuersignal abhängt.

Das von der gesteuerten Stromsenke 118 erzeugte Gleichstromsignal wird über den zweiten elektrischen Schaltpfad, d.h. über den Hinleiter 98b, den im sicheren Zustand des Schutzgeräts 24 geschlossenen Schalter 96b und den Rückleiter 100b, zu dem Stromrichtungselement 120 übertragen. Wie an dieser Stelle deutlich wird, beziehen sich die Bezeichnungen der Leiter 98b, 100b als "Hin"-leiter bzw. "Rück"-leiter nicht auf die technische Stromflussrichtung, sondern auf die Signalflussrichtung, die im Falle des Schalters 96b der technischen Stromflussrichtung entgegen gesetzt ist, da die Stromsenke 118 ein durch einen eingehenden Strom definiertes Stromsignal erzeugt und überträgt.

Das Stromrichtungselement 120 ist dazu ausgebildet, an seinem Ausgang ein von dem empfangenen Gleichstromsignal abhängiges Gleichspannungssignal auszugeben. Das Stromrichtungselement 120 erzeugt ein dem empfangenen Stromsignal entsprechendes Spannungssignal, so lange der Wert des über den zweiten Schaltpfad übertragenen, von dem Stromrichtungselement 120 empfangenen und durch einen ausgehenden Strom des Stromrichtungselements 120 definierten Stromsignals zwischen einem erwarteten niedrigen Pegel, z.B. 0 mA, und einem erwarteten hohen Pegel, z.B. 10 mA, wechselt. In diesem Fall erzeugt das Stromrichtungselement 120 bevorzugt an seinem Ausgang ein Gleichspannungssignal, welches dem an seinem Eingang empfangenen Stromsignal entspricht, d.h. dass ein hoher ausgehender Strompegel des Stromsignals mit einem hohen Spannungspegel des Spannungssignals korrespondiert und ein niedriger ausgehender Strompegel des Stromsignals mit einem niedrigen Pegel des Spannungssignals korrespondiert.

Das Stromrichtungselement 120 ist ferner dazu eingerichtet, zu erkennen, wenn - entgegen der Erwartung bei fehlerfreiem Betrieb - an dem Stromrichtungselement 120 ein eingehender Stromfluss vorliegt, und/oder zu erkennen, wenn zwar ein ausgehender Stromfluss an dem Stromrichtungselement 120 vorliegt, dessen Pegel aber zumindest für eine bestimmte Zeit keinem bei einem fehlerfreien Betrieb des Sicherheitsteilnehmers 22 erwarteten Pegel entspricht, d.h. vorliegend weder dem bei fehlerfreiem Betrieb erwarteten hohen Pegel noch dem bei fehlerfreiem Betrieb erwarteten niedrigen Pegel des über den zweiten elektrischen Schaltpfad übertragenen Stromsignals. Beispielsweise kann ein Fehler angenommen werden, wenn der Wert des ausgehenden Stroms an dem Stromrichtungselement 120 unter dem erwarteten hohen Pegel des Stromsignals von der Stromsenke 118 und über dem erwarteten niedrigen Pegel des Stromsignals von der Stromsenke 118 liegt. In den vorstehenden Fällen erzeugt das Stromrichtungselement 120 an seinem Ausgang vorzugsweise ein Spannungssignal, das zu einer Verletzung der Erwartungshaltung der Sicherheitssteuerung führt, ggf. in Zusammenwirken mit der nachstehend erläuterten Dynamikeinheit 122. Das Stromrichtungselement 120 erzeugt beispielsweise ein Spannungssignal mit einem Pegel, der dauerhaft bzw. zumindest für eine vollständige Testzyklusdauer, d.h. die Dauer von dem Beginn einer Testlücke bis zu dem Beginn der nächsten Testlücke des von der Sicherheitssteuerung erwarteten Testsignals, einen im Wesentlichen konstanten Wert annimmt.

Das Stromrichtungselement 120 kann, wie in Fig. 4 gezeigt, eine Zenerdiode 121 umfassen, die in Richtung des aus dem Stromrichtungselement 120 ausgehenden Stroms gepolt ist, wobei die Zenerdiode 121 aber nicht unbedingt erforderlich ist. Diese Zenerdiode 121 kann sich bei einem erwarteten hohen Pegel des aus dem Stromrichtungselement 120 ausgehenden Stromflusses in ihrem Durchlassbereich befinden, in der eine Spannung an der Zenerdiode 121 anliegt, die im Bereich einer Durchlassspannung der Zenerdiode 121 liegt, und kann sich bei einem demgegenüber verringerten aus dem Stromrichtungselement 120 ausgehenden Stromfluss in einem Sperrbereich befinden, in dem eine geringere als die Durchlassspannung an der Zenerdiode 121 anliegt.

Schließlich ist eine Dynamikeinheit 122 vorgesehen, die an ihrem Eingang das von dem Stromrichtungselement 120 erzeugte Spannungssignal empfängt und dazu eingerichtet ist, das empfangene Signal im Wesentlichen unverändert weiterzuleiten, wenn das empfangene Signal die erwartete Dynamik aufweist. Wenn das empfangene Signal nicht die erwartete Dynamik aufweist, gibt die Dynamikeinheit ein Signal mit einem konstanten Pegel aus. Die Dynamikeinheit bildet dabei sowohl einen konstant hohen Pegel ("High") ihres Eingangssignals als auch einen konstant niedrigen Pegel ("Low") ihres Eingangssignals auf denselben Pegel ihres Ausgangssignals ab (je nach Anwendung "High" oder "Low").

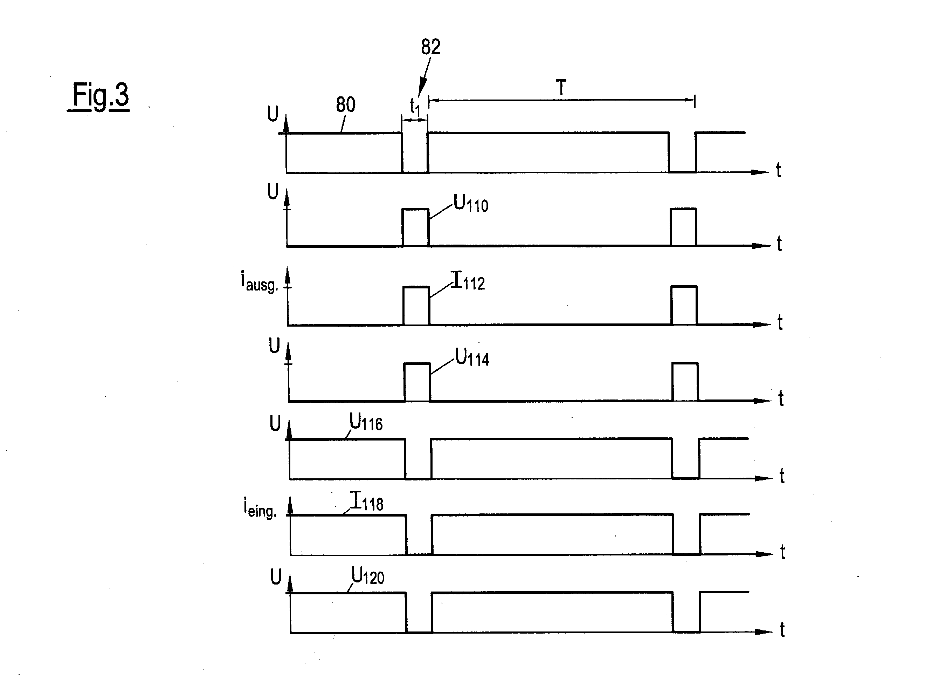

Im Folgenden wird die Funktionsweise der Testschaltung 62 unter Bezugnahme auf die Fig. 2 und Fig. 3 erläutert, wobei Fig. 3 die Strom- und Spannungssignale zeigt, die auf den zwischen den Komponenten der Testschaltung 62 angeordneten Abschnitten des Testsignalpfads 36 bei fehlerfreier Funktion des Sicherheitsteilnehmers 22 und im sicheren Zustand des Schutzgeräts 24, in dem die beiden Schalter 96a, 96b geschlossen sind, jeweils vorhanden sind. Ganz oben in Fig. 2 ist das an dem Testsignaleingang 106 eingehende, auf der elektrischen Spannung U basierende Testsignal 80 gezeigt, wie es von der Sicherheitssteuerung 10 an dem Ausgang X1 bereitgestellt wird. Der Invertierer 110 erzeugt ein zu dem empfangenen Testsignal 80 invertiertes Spannungssignal U₁₁₀, d.h. ein wie in Fig. 3 gezeigtes Spannungssignal U₁₁₀ mit einem niedrigen Spannungspegel während des hohen Signalpegels des eingehenden Testsignals 80 und einem hohen Spannungspegel in der Form eines Testpulses während der Testlücke 82 des empfangenen Testsignals 80. Die gesteuerte Stromquelle 112 erzeugt daraus ein durch einen ausgehenden Strom i_{ausg} der Stromquelle 112 gebildetes Stromsignal I₁₁₂ mit einer zu dem Spannungssignal U₁₁₀ im Wesentlichen identischen Form, d.h. einem Strompuls mit einem hohen ausgehenden Strompegel während der Testlücke 82 des empfangenen Testsignals 80 und einem niedrigen Strompegel zwischen zwei Strompulsen.

Dieses Stromsignal I₁₁₂ wird zu dem Stromflusselement 114 übertragen, welches aus dem übertragenen Stromsignal I₁₁₂ ein Spannungssignal U₁₁₄ generiert, das in seiner Form mit dem von dem Invertierer 110 erzeugten Spannungssignal U₁₁₀ identisch ist. Das von dem Stromflusselement 114 erzeugte Spannungssignal U₁₁₄ wird durch den Invertierer 116 invertiert, so dass dieser an seinem Ausgang ein Spannungssignal U₁₁₆ bereitstellt und an die gesteuerte Stromsenke 118 übermittelt, welches in seiner Form mit dem an dem Testsignaleingang 106 empfangenen Testsignal 80 identisch ist. Die Stromsenke 118 erzeugt daraus ein durch einen eingehenden elektrischen Strom i_{eing} der Stromsenke 118 gebildetes Stromsignal I₁₁₈, das in seiner Form mit dem von dem Invertierer 116 gelieferten Spannungssignal U₁₁₆ identisch ist und über den Schalter 96b zu dem Stromrichtungselement 120 übertragen wird, welches daraus ein Spannungssignal U₁₂₀ erzeugt, das in seiner Form mit dem von der Stromsenke 118 gelieferten Stromsignal I₁₁₈ und folglich mit dem an dem Testsignaleingang 106 eingehenden Testsignal 80 identisch ist. Die Dynamikeinheit 122 leitet das Signal U₁₂₀ im Wesentlichen unverändert weiter, wenn das Signal U₁₂₀ die erwartete Dynamik aufweist. Andernfalls gibt die Dynamikeinheit 122 ein Signal mit einem im Wesentlichen konstanten Pegel aus. Das Ausgangssignal der Dynamikeinheit 122 wird an dem Testsignalausgang 108 des Sicherheitsteilnehmers 22 bereitgestellt.

Somit wird bei fehlerfreiem Sicherheitselement 22 und im sicheren Zustand des Schutzgeräts 24 an dem Testsignalausgang 108 ein Testsignal bereitgestellt, welches mit dem an dem Testsignaleingang 106 empfangenen Testsignal im Hinblick auf die von der Sicherheitssteuerung 10 überprüften Eigenschaften, insbesondere Signalform und Signalsynchronität, identisch ist, so dass die Erwartungshaltung der Sicherheitssteuerung erfüllt wird.

Wird zumindest einer der Schalter 96a, 96b des Schutzgeräts 24 bei dem Eintreten eines nicht sicheren Zustands des Schutzgeräts 24 geöffnet, wird das Stromflusselement 114 und/oder das Stromrichtungselement 116 nicht mehr durch das eingehende Testsignal 80 angeregt, was zu einem Verlust der Dynamik des an dem Ausgang 108 ausgegebenen Testsignals und somit zuverlässig zu einer Sicherheitsabschaltung durch die Sicherheitssteuerung führt. Dieselbe Wirkung hat eine Leitungsunterbrechung eines Hinleiters 98a, 98b oder Rückleiters 100a, 100b in der Anschaltungsleitung 30, so dass auch in diesem Fehlerfall zuverlässig eine Sicherheitsabschaltung erfolgt. Im Falle der Unterbrechung des Hinleiters 98a oder Rückleiters 100a liegt an dem Ausgang des Invertierers 116 dauerhaft ein hoher Pegel an, so dass eine permanente Ansteuerung der Stromsenke 118 erfolgt und somit ein dauerhafter eingehender Stromfluss am Ausgang der Stromsenke 118 ohne die erwartete Signaldynamik auftritt. Im Falle der Unterbrechung des Hinleiters 98b oder Rückleiters 100b wird an dem Stromrichtungselement 120 dauerhaft kein ausgehender Strom erzeugt, so dass dessen Ausgangssignal U₁₂₀ einen dauerhaft niedrigen Pegel ohne die erwartete Signaldynamik annimmt.

Zudem bewirkt die Testschaltung 62, dass auch ein Querschluss zwischen den beiden Schaltpfaden, d.h. ein Querschluss zwischen dem Hinleiter 98a und/oder Rückleiter 100a eines elektrischen Schaltpfads mit dem Hinleiter 98b und/oder Rückleiter 100b des anderen elektrischen Schaltpfads erkannt wird und zu einer Sicherheitsabschaltung führt. Im Falle eines solchen Querschlusses wird der zweite Schaltpfad unmittelbar mit der Stromquelle 112 verbunden, welche im Falle eines Signals mit einem hohen Pegel an ihrem Steuereingang einen ausgehenden Stromfluss antreibt. Die Stromquelle 112 wirkt somit einem ausgehenden Stromfluss an dem Stromrichtungselement 120 entgegen, so dass sich an dem Stromrichtungselement 120 zumindest zeitweise ein eingehender Stromfluss einstellt oder zumindest ein Stromfluss mit einem zumindest für eine bestimmte Zeit vorliegenden Pegel, der sich von dem bei fehlerfreiem Betrieb erwarteten Pegel des Stromsignals I₁₁₈ unterscheidet und beispielsweise unterhalb des erwarteten hohen Pegels und gleichzeitig oberhalb des erwarteten niedrigen Pegels von z.B. 0 mA liegt. Das Stromrichtungselement 120 ist dazu ausgebildet, eine solche Abweichung von dem fehlerfreien Betrieb anhand des Stromflusses durch das Stromrichtungselement 120 zu erkennen und in diesem Fall ein Spannungssignal U₁₂₀ an seinem Ausgang zu erzeugen, welches vorzugsweise einen dauerhaft konstanten Spannungspegel aufweist und welches zu einem die Erwartungshaltung der Sicherheitssteuerung 10 verletzenden Testsignal an dem Testsignalausgang 108 führt. Somit wird auch dieser Fehlerfall, der aufgrund der parallelen Führung der Hinleiter 98a, 98b und Rückleiter 100a, 100b beider elektrischer Schaltpfade in einem gemeinsamen Anschaltungskabel 28 prinzipiell auftreten kann, zuverlässig erkannt und kann somit nicht zu einem Verlust der Sicherheitsfunktion führen.

Die Testschaltung 62 wird dabei allein durch das an dem Eingang 106 empfangene Testsignal angeregt und die Dynamik des an dem Ausgang 108 ausgegebenen Testsignals wird allein durch die Dynamik dieses eingehenden Testsignals erzeugt. Die Testschaltung 62 kommt dementsprechende vollständig ohne eigene Zeitbasis und insbesondere ohne einen eigenen Taktgeber aus und die hierin beschriebenen Bestandteile der Testschaltung 62 können sämtlich durch diskrete Bauteile gebildet sein, d.h. dass auf die Verwendung eines integrierten Schaltkreises wie z.B. eines Mikroprozessors verzichtet werden kann. Die Zuverlässigkeit und Fehlersicherheit der Testschaltung 62 wird dadurch erheblich gesteigert. Außerdem wird eine Verzögerung zwischen dem an dem Testsignaleingang 106 eingehenden Testsignal und dem an dem Testsignalausgang 108 ausgehenden Testsignal weitestgehend vermieden und die Ansprechzeit des Sicherheitssystems insgesamt optimiert.

In dem vorstehend beschriebenen Ausführungsbeispiel einer Testschaltung 62 bilden der Invertierer 110 und die nicht-invertierende gesteuerte Stromquelle 112 zusammen eine invertierende gesteuerte Stromquelle und der Invertierer 116 und die nicht-invertierende gesteuerte Stromsenke 118 bilden zusammen eine invertierende gesteuerte Stromsenke. Anstelle des Aufbaus dieser gesteuerten invertierenden Stromquelle bzw. -senke aus separaten Bauteilen, nämlich aus dem Invertierer 110, 116 und der gesteuerten nicht-invertierenden Stromquelle 112 bzw. -senke 118, könnte jeweils auch eine einteilige gesteuerte invertierende Stromquelle bzw. - senke eingesetzt werden, d.h. eine gesteuerte Stromquelle bzw. Stromsenke, die bei einem hohen Pegel des Steuersignals einen ausgehenden bzw. eingehenden Strom mit einem niedrigen Pegel erzeugt und die bei einem niedrigen Pegel des Steuersignals einen ausgehenden bzw. eingehenden Strom mit einem hohen Pegel erzeugt. Ebenso kann prinzipiell auf das Stromflusselement 114 verzichtet werden bzw. dessen Funktion in den Invertierer 116 oder eine invertierende gesteuerte Stromsenke integriert werden, indem ein stromgesteuerter Invertierer bzw. eine stromgesteuerte invertierende Stromsenke verwendet wird.

Die die Sicherheit erhöhende Funktionalität der vorstehend beschriebenen Testschaltung 62 kann auch erreicht werden, wenn Stromquelle 112 und Stromsenke 118 gegenüber der beschriebenen Ausführungsform vertauscht sind. An dem Stromrichtungselement 120 wird dann bei fehlerfreiem Betrieb ein eingehender Stromfluss erwartet, der durch die Stromquelle 112 erzeugt wird, so dass das Stromrichtungselement 120 bevorzugt dazu ausgebildet ist, einen Fehler daran zu erkennen, dass unerwarteter Weise ein ausgehender Stromfluss an dem Stromrichtungselement auftritt oder ein eingehender Stromfluss, der keinen bei fehlerfreiem Betrieb erwarteten Pegel aufweist. Die mit dem Hinleiter 98a verbundene Diode 124 ist in diesem Fall der eingehenden Stromrichtung an der Stromsenke 118 entsprechend mit umgekehrter Polung anzubinden.

Fig. 4 zeigt einen Sicherheitsteilnehmer 22, der dem in Fig. 3 gezeigten Sicherheitsteilnehmer 22 entspricht, wobei zusätzlich eine Auswerteeinheit 50 mit einem Mikroprozessor 52 und ein in dem Testsignalpfad 36 zwischen der Dynamikeinheit 122 und dem Testsignalausgang 108 angeordneter Unterbrechungsschalter 66 gezeigt sind.

Die Auswerteeinheit 50 ist über mehrere Signalpfade 54 mit der Testschaltung 62 und mit den durch die Schalter 96a, 96b und die Hin- und Rückleiter 98a, 98b, 100a, 100b gebildeten elektrischen Schaltpfaden derart verbunden, dass die Auswerteeinheit 50 über die Signalpfade 54 den Schaltzustand jedes der beiden elektrischen Schaltpfade überwachen kann. Die Auswerteeinheit 50 ist dazu eingerichtet, kontinuierlich zu überprüfen, ob die zwei elektrischen Schaltpfade gemeinsam unterbrochen werden, und um den Unterbrechungsschalter 66 zu öffnen, wenn die zwei Schaltpfade nicht gemeinsam unterbrochen werden. Die Auswerteeinheit 50 ist dabei über einen weiteren Signalpfad 54 mit dem Unterbrechungsschalter 66 verbunden, um diesen ansteuern und dadurch öffnen oder schließen zu können. Die Auswerteeinheit 50 überprüft dabei, ob die beiden elektrischen Schaltpfade, gegebenenfalls bis auf eine vorgegebene zeitliche Toleranz, gleichzeitig unterbrochen werden. Um die Gleichzeitigkeit festzustellen, weist die Auswerteeinheit 50 eine eigene Zeitbasis auf, die beispielsweise durch einen Taktgeber des Mikroprozessors 52 gebildet sein kann.

Auch wenn der Testsignalpfad 36 bei einem Öffnen zumindest eines der Schalter 96a, 96b ohnehin bereits unterbrochen wird und die Sicherheitsfunktion anspricht, wird die Sicherheit des Gesamtsystems durch die Auswerteeinheit 50 erhöht. So öffnet die Auswerteeinheit 50 den Überbrückungsschalter 66 nach dem Erkennen eines nicht gemeinsamen Unterbrechens beider Schaltpfade vorzugsweise permanent, auch wenn das Schutzgerät 24 wieder in den sicheren Zustand mit geschlossenen Schutzkanälen zurückkehrt, bis der Fehler, beispielsweise durch eine Benutzereingabe, quittiert wird bzw. die Funktionstüchtigkeit des Sicherheitsteilnehmers 22 wieder hergestellt ist. Bis dahin wird ein Wiederaktivieren des Sicherheitssystems verhindert, sodass eine Tolerierung des vorhandenen Fehlers ausgeschlossen ist.

In Fig. 4 ist ferner ein Signalverstärker oder Signaltreiber 125 gezeigt, der zwischen dem Unterbrechungsschalter 66 und dem Testsignalausgang 108 angeordnet ist und das ausgehende Testsignal des Sicherheitsteilnehmers 22 signaltreibend an den nachfolgenden Abschnitt des Testsignalpfads 36 ausgibt.

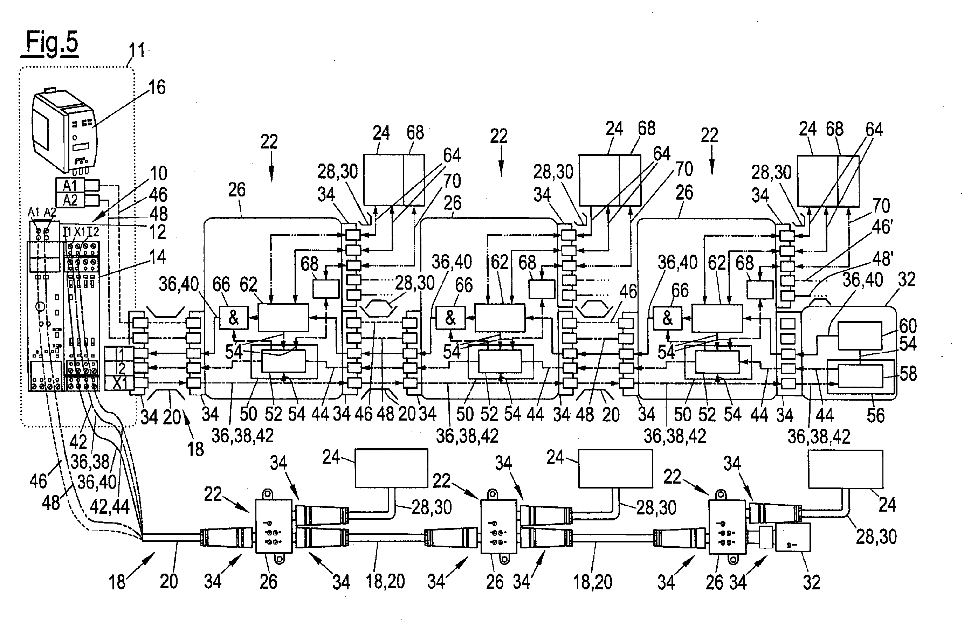

Fig. 5 zeigt ein Sicherheitssystem gemäß einer weiteren Ausführungsform der Erfindung, welche abgesehen von den nachstehend beschriebenen Unterschieden im Wesentlichen der in Fig. 1 gezeigten Ausführungsform entspricht und mehrere Sicherheitsteilnehmer 22 aufweist. Die in Fig. 5 gezeigten Sicherheitsteilnehmer 22 können alle wie vorstehend in Bezug auf Fig. 1 bis 4 beschrieben ausgebildet sein, es können aber auch ein oder mehrere solche Sicherheitsteilnehmer 22 mit beliebigen andersartigen Sicherheitsteilnehmern 22 kombiniert werden. Der obere Teil der kombinierten Darstellung in Fig. 5 ist dabei eine schematische Ansicht und der untere Teil der kombinierten Darstellung in Fig. 5 eine im Wesentlichen fotographische Ansicht desselben Sicherheitssystems. Sich in beiden Darstellungen entsprechende Elemente tragen dieselben Bezugszeichen.

Das Sicherheitssystem umfasst eine Sicherheitssteuerung 10, die in einem Schaltschrank 11 angeordnet ist und ein Hauptmodul 12 und ein Ein-/Ausgangsmodul 14 umfasst, die über eine nicht dargestellte Busschiene miteinander verbunden sind, wobei das Ein-/Ausgangsmodul 14 einen Ausgang X1, einen Sicherheitseingang I1 sowie einen nicht sicheren Standardeingang I2 umfasst. In dem Schaltschrank 11 ist ferner eine als Schaltnetzteil ausgebildete Stromversorgungseinheit 16 zur Stromversorgung des Sicherheitssystems angeordnet, die eine konstante Spannung mit einem hohen Pegel von beispielsweise 24 Volt bezogen auf Masse und ein Massepotential bzw. eine konstante Spannung mit einem niedrigen Pegel von z.B. 0 Volt bereitstellt, wobei die Spannung mit dem hohen Pegel an einen Anschluss A1 des Hauptmoduls 12 und die Spannung mit dem niedrigen Pegel an einen Anschluss A2 des Hauptmoduls 12 geliefert wird.

Das Sicherheitssystem umfasst eine Busleitung 18 mit mehreren Buskabeln 20, wobei eines der Buskabel 20 an die Sicherheitssteuerung 10 angeschlossen ist. Das Sicherheitssystem umfasst ferner mehrere Sicherheitsteilnehmer 22, die über die Buskabel 20 in einer Linie hintereinander geschaltet und über die Busleitung 18 mit der Sicherheitssteuerung 10 verbunden sind. Am Ende der durch die Sicherheitsteilnehmer 22 gebildeten Linie befindet sich ein Abschlusselement 32, welches hier direkt, d.h. ohne ein zwischengeschaltetes Kabel, mit dem letzten Sicherheitsteilnehmer 22 der Linie verbunden ist. Prinzipiell könnte das Abschlusselement 32 auch durch ein weiteres Buskabel an die Busleitung 18 angeschlossen sein.

Die Schutzgeräte 24, Anschaltungsmodule 26 und das Abschlusselement 32 weisen jeweils ein eigenes Gehäuse auf, welches vorzugsweise nach der Gehäuseschutzart IP 67 oder IP 20 oder einer sonstigen gegen Schmutz oder Feuchtigkeit schützenden Gehäuseschutzart ausgebildet ist.

Die Busleitung 18 und die an die Busleitung 18 angeschlossenen Sicherheitsteilnehmer 22 bilden einen Testsignalpfad 36 mit einem mit dem Ausgang X1 der Sicherheitssteuerung 10 verbundenen Hinleitungspfad 38 und einem mit dem Sicherheitseingang I1 der Sicherheitssteuerung 10 verbundenen Rückleitungspfad 40, wobei der Hinleitungspfad 38 und der Rückleitungspfad 40 über das Abschlusselement 32 miteinander verbunden sind und sowohl der Hinleitungspfad 38 als auch der Rückleitungspfad 40 durch die Sicherheitsteilnehmer 22 hindurch verlaufen. Ferner bilden die Sicherheitsteilnehmer 22, die Busleitung 18 und das Abschlusselement 32 einen Datenpfad 42 aus, der einen durch den Hinleitungspfad 38 des Testsignalpfads 36 gebildeten, d.h. mit diesem identischen, Datenhinleitungspfad und einen separaten, an den Eingang I2 der Sicherheitssteuerung 10 angeschlossenen Datenrückleitungspfad 44 umfasst, die zusammen eine Ringbusleitung bilden. Der Datenpfad 42 dient zur Übertragung von Daten zwischen der Sicherheitssteuerung 10 und den Sicherheitsteilnehmern 22 und ggf. dem Abschlusselement 32 zusätzlich zu der über den Testsignalpfad 36 übertragenen Sicherheitsinformation. Ferner sind eine über den Anschluss A1 des Hauptmoduls 12 geführte erste Stromversorgungsleitung 46 und eine über den Anschluss A2 des Hauptmoduls 12 geführte zweite Stromversorgungsleitung 48 vorgesehen, über die die Sicherheitssteuerung 10, die Sicherheitsteilnehmer 22 und das Abschlusselement 32 mit Strom versorgt werden. Wie in Fig. 5 am Beispiel des rechten Sicherheitsteilnehmers 22 mit Bezugszeichen angedeutet, können die Anschaltungskabel 30 jeweils eine erste und zweite Stromversorgungsader 46', 48' umfassen, über die das jeweilige Schutzgerät 24 an die erste und zweite Stromversorgungsleitung 46, 48 anschließbar und dadurch mit Strom versorgbar ist.

Wie in Fig. 5 gezeigt, sind der Testsignalpfad 36, der Datenpfad 42, die erste Stromversorgungsleitung 46 und die zweite Stromversorgungsleitung 48 in der gemeinsamen Busleitung 18 angeordnet und werden alle in denselben gemeinsamen Buskabeln 20 der Busleitung 18 geführt. Die Buskabel 20 weisen dabei jeweils eine elektrisch leitfähige Ader für den Hinleitungspfad 38 des Testsignalpfads 36, der gleichzeitig den Datenhinleitungspfad darstellt, für den Datenrückleitungspfad 44, für die erste Stromversorgungsleitung 46 und für die zweite Stromversorgungsleitung 48 auf, so dass die gesamte Verkabelung der Sicherheitsteilnehmer 22 mit der Sicherheitssteuerung 10 durch eine linienförmige Busleitung 18 aus Buskabeln 20 mit jeweils mindestens fünf Adern realisiert ist. Es ist somit nur genau ein Buskabel 20 erforderlich, um zwei benachbarte Sicherheitsteilnehmer 22 miteinander bzw. mit der Sicherheitssteuerung 10 zu verbinden.

Von der Sicherheitssteuerung 10 wird ein Ausgangssignal erzeugt und über den Ausgang X1 an den Hinleitungspfad 38 ausgesendet. Dieses Ausgangssignal wird in den Anschaltungsmodulen 26 der Sicherheitsteilnehmer 22, wie in Fig. 5 ersichtlich, direkt und ohne Unterbrechungsmöglichkeit im Wesentlichen unverändert durchgeschleift und zu dem Abschlusselement 32 übertragen. Gleichzeitig ist in den Anschaltungsmodulen 26 jeweils eine Auswerteeinheit 50 mit einem Mikroprozessor 52 vorgesehen. Die Auswerteeinheit 50 mit dem Mikroprozessor 52, die die hierin beschriebene Diskrepanzüberprüfung durchführt und den Unterbrechungsschalter 66 ansteuert, erfüllt in diesem Ausführungsbeispiel noch weitere Funktionen und kann in diesem Zusammenhang auch als Logikeinheit bezeichnet werden. Die Auswerteeinheit 50 ist über einen Signalpfad 54 mit dem Hinleitungspfad 38 verbunden und dazu eingerichtet, das auf dem Hinleitungspfad 38 übertragene Ausgangssignal zu überwachen, beispielsweise zum Zweck einer Synchronisierung.

Das von der Sicherheitssteuerung erzeugte, über den Hinleitungspfad 38 ausgesendete Ausgangssignal basiert auf elektrischer Spannung und weist mit einer vorgegebenen Zykluszeit periodisch auftretende Synchronisationsmerkmale und zwischen den Synchronisationsmerkmalen angeordnete Datenmerkmale auf, die jeweils ein Datenbit der von der Sicherheitssteuerung 10 gesendeten Ausgangsdaten repräsentieren.

Das Abschlusselement 32 ist dazu eingerichtet, das Ausgangssignal von dem Hinleitungspfad 38 zu empfangen und in Abhängigkeit von dem von dem Hinleitungspfad 38 empfangenen Ausgangssignal ein gegenüber dem empfangenen Ausgangssignal verändertes Testsignal an den Rückleitungspfad 40 des Testsignalpfads 36 auszusenden. Das über den Rückleitungspfad 40 übertragene Testsignal unterscheidet sich somit von dem von der Sicherheitssteuerung 10 ausgesendeten Ausgangssignal. Das Abschlusselement 32 weist dazu ebenfalls eine mit dem Hinleitungspfad 38 verbundene Logikeinheit 56 mit einem Mikroprozessor 58 auf, die das über den Hinleitungspfad 38 übertragene Ausgangssignal empfängt und auswertet. Die Logikeinheit 56 ist mit einem Testsignalgenerator 60 des Abschlusselements 32 verbunden und steuert diesen an, um aktiv ein Testsignal zu generieren und an den mit dem Testsignalgenerator 60 verbundenen Rückleitungspfad 40 des Testsignalpfads 36 signaltreibend auszusenden.

Der Rückleitungspfad 40 des Testsignalpfads 36 verläuft durch die Sicherheitsteilnehmer 22 hindurch. Diese sind dazu eingerichtet, den Rückleitungspfad 40 bei Vorliegen bzw. Eintreten eines nicht sicheren Zustands ihres jeweiligen Schutzgeräts 24 zu unterbrechen. Die Anschaltungsmodule 26 weisen jeweils eine z.B. wie vorstehend beschrieben ausgebildete Testschaltung 62 auf, die wie beschrieben über Verbindungen 64 der Anschaltungsleitung 30 mit den in der Regel zwei Schutzkanälen des jeweiligen Schutzgeräts 24 verbunden ist, wobei die Testschaltung 62 in Zusammenwirken mit den Schutzkanälen des Schutzgeräts 24 ein Ansprechen der Sicherheitsfunktion bei Vorliegen eines nicht sicheren Zustands des Schutzgeräts 24 bewirkt.

Die Logikeinheiten 56, 50 des Abschlusselements 32 und der Anschaltungsmodule 26 sind jeweils in dem Datenpfad 42 bzw. Datenrückleitungspfad 44 angeordnet und dazu eingerichtet, Daten über den Datenpfad 42 zu empfangen und an den Datenrückleitungspfad 44 zu senden. Die von einem Sicherheitsteilnehmer 22 erzeugten und über den Datenrückleitungspfad 44 gesendeten Daten umfassen vorzugsweise von dem jeweiligen Sicherheitsteilnehmer 22 erzeugte Diagnose- und/oder Statusinformationen. Insbesondere können diese Informationen den sicherheitsrelevanten Schaltzustand des jeweiligen Schutzgeräts 24 wiedergeben, der auch für die Unterbrechung des Testsignalpfads ausschlaggebend ist, d.h. den von dem Schutzgerät 24 eingenommenen Zustand "sicher" oder "nicht sicher". Dadurch wird es der Sicherheitssteuerung 10 ermöglicht, im Fall einer Auslösung einer Sicherheitsabschaltung festzustellen, durch welchen Sicherheitsteilnehmer 22 die Abschaltung verursacht wurde. Auch können die von einem Sicherheitsteilnehmer 22 an die Sicherheitssteuerung übertragenen Daten einen aufgetretenen Diskrepanzfehler und vorzugsweise den fehlerhaften Sicherheitsteilnehmer 22 identifizieren.

Die Anschaltungsmodule 26 weisen jeweils eine über einen Signalpfad 54 mit der Logikeinheit 50 verbundene, insbesondere binäre, Ein-/Ausgabeschnittstelle 68 auf, die über wenigstens eine in der Anschaltungsleitung 30 vorgesehene Signalader 70 mit einer, insbesondere binären und/oder nicht sicheren Ein-/Ausgabe-Schnittstelle 68 des Schutzgeräts 24 verbunden ist, um über den Datenrückleitungspfad 44 empfangene Daten an das Schutzgerät 24 zu übertragen und/oder um von dem Schutzgerät 24 erzeugte Ausgangsdaten über den Datenrückleitungspfad 44 an die Sicherheitssteuerung 10 zu senden.

Die Sicherheitssteuerung 10 ist dazu eingerichtet, das über den Rückleitungspfad 40 des Testsignalpfads 36 übertragene Signal zu empfangen und mit einer in der Sicherheitssteuerung 10 konfigurierten Erwartungshaltung zu vergleichen. Da sich das bei dem Betrieb des Sicherheitssystems über den Rückleitungspfad 40 übertragene Testsignal von dem über den Hinleitungspfad 38 übertragenen Ausgangssignal unterscheidet und nur das Testsignal der Erwartungshaltung der Sicherheitssteuerung 10 entspricht, führt z.B. ein Querschluss zwischen dem Hinleitungspfad 38 und dem Rückleitungspfad 40 des Testsignalpfads 36 zu einem Ausbleiben des erwarteten Signals an dem Sicherheitseingang I1. Ein solcher Funktionsfehler, wie er beispielsweise bei einer Quetschung eines Buskabels 20 auftreten kann, führt folglich zuverlässig zu einer Verletzung der Erwartungshaltung der Sicherheitssteuerung und zu einer Sicherheitsabschaltung, so dass eine Tolerierung eines solchen Fehlerzustands durch die Sicherheitsteuerung 10 ausgeschlossen ist.

Der Hinleitungspfad 38 des Testsignalpfads 36 bildet mit dem Datenrückleitungspfad 44 einen als Ringbus ausgebildeten ringförmigen Datenpfad 42, über den die Sicherheitssteuerung 10, das Abschlusselement 32 und die Sicherheitsteilnehmer 22 miteinander kommunizieren und zwar nach Art einer nachstehend beschriebenen Daisy-Chain-Buskommunikation, insbesondere nach dem Master-Slave-Prinzip. Die Sicherheitssteuerung 10, das Abschlusselement 32 und die Sicherheitsteilnehmer 22 bilden dabei die Teilnehmer der Buskommunikation, wobei die Sicherheitssteuerung 10 gleichzeitig den Busmaster darstellt.

Um Daten von dem Datenpfad 42 zu empfangen und Daten über den Datenpfad 42 zu senden, ist jeder Teilnehmer 22, 32 dazu ausgebildet, an einem Eingang ein über den Datenpfad 42 übertragenes eingehendes Datensignal zu empfangen, die empfangenen Daten zu verarbeiten, und bevorzugt gleichzeitig an einem von dem Eingang verschiedenen Ausgang ein ausgehendes Datensignal an den Datenpfad 42 auszusenden, so dass die Teilnehmer 22, 32 eine Nachrichtenkette bilden, in der die Daten in einer vorgegebenen Datenflussrichtung von einem Teilnehmer 22, 32 zum nächsten übertragen werden. Die Logikeinheiten 50, 56 der Sicherheitsteilnehmer 22 und des Abschlusselements 32 dienen dabei als Sende- und Empfangsschaltung, über die der jeweilige Teilnehmer 22, 32 Daten empfängt und sendet.

### Bezugszeichenliste

- 10: Sicherheitssteuerung
- 11: Schaltschrank
- 12: Hauptmodul
- 14: Ein-/Ausgangsmodul
- 16: Stromversorgungseinheit
- 18: Busleitung
- 20: Buskabel
- 22: Sicherheitsteilnehmer
- 24: Schutzgerät
- 26: Anschaltungsmodul
- 28: Anschaltungskabel
- 30: Anschaltungsleitung
- 32: Abschlusselement
- 34: Steckverbindung
- 36: Testsignalpfad
- 38: Hinleitungspfad, Datenhinleitungspfad
- 40: Rückleitungspfad des Testsignalpfads
- 42: Datenpfad
- 44: Datenrückleitungspfad
- 46: erste Stromversorgungsleitung
- 46': erste Stromversorgungsader
- 48: zweite Stromversorgungsleitung
- 48': zweite Stromversorgungsader
- 50: Auswerteeinheit, Logikeinheit
- 52: Mikroprozessor
- 54: Signalpfad
- 56: Logikeinheit
- 58: Mikroprozessor
- 60: Testsignalgenerator
- 62: Testschaltung
- 64: Verbindung
- 66: Unterbrechungsschalter
- 68: Ein-/Ausgabeschnittstelle
- 70: Signalader
- 80: Testsignal
- 82: Testlücke
- 96a, 96b: Schalter
- 98a, 98b: Hinleiter
- 100a, 100b: Rückleiter
- 106: Testsignaleingang
- 108: Testsignalausgang
- 110: Invertierer
- 112: gesteuerte Stromquelle
- 114: Stromflusselement
- 116: Invertierer
- 118: gesteuerte Stromsenke
- 120: Stromrichtungselement
- 121: Zenerdiode
- 122: Dynamikeinheit
- 124: Diode
- 125: Signalverstärker
- A1: Gleichspannungsanschluss
- A2: Masseanschluss
- i_{eing}: eingehender elektrischer Strom
- i_{ausg}: ausgehender elektrischer Strom
- I₁₁₂, I₁₁₈: Stromsignal
- I1: Sicherheitseingang
- I2: Eingang
- U: elektrische Spannung
- 80, U₁₁₀, U₁₁₄: Spannungssignal
- U₁₁₆, U₁₂₀: Spannungssignal
- X1: Ausgang

## Patentansprüche

1. Anschaltungsmodul (26) zur Einbindung eines Schutzgeräts (24) in ein Sicherheitssystem, welches umfasst
- wenigstens einen Testsignalpfad, der zwischen einem Testsignaleingang (106) für ein eingehendes Testsignal (80) und einem Testsignalausgang (108) für ein ausgehendes Testsignal des Anschaltungsmoduls (26) angeordnet ist,
- ein erstes und ein zweites Paar von jeweils einem Signaleingang und einem Signalausgang, wobei der Signaleingang und der Signalausgang eines Paares jeweils zur Einbindung eines elektrischen Schaltpfads in den Testsignalpfad ausgebildet sind, und
- eine Testschaltung (62) für die beiden Schaltpfade,
**dadurch gekennzeichnet, dass**
die Testschaltung (62) eine gesteuerte Stromquelle (112), eine gesteuerte Stromsenke (118) und ein Stromrichtungselement (120) umfasst,
wobei der Testsignaleingang (106) des Anschaltungsmoduls (26) mit einem Steuereingang der gesteuerten Stromquelle (112) oder der gesteuerten Stromsenke (118) verbunden ist, so dass die gesteuerte Stromquelle (112) oder Stromsenke (118) durch das eingehende Testsignal (80) oder ein davon abgeleitetes Signal (U₁₁₀) ansteuerbar ist und wobei ein gesteuerter Ausgang derselben von Stromquelle (112) und Stromsenke (118) mit dem Signalausgang des ersten Paares von Signalausgang und Signaleingang verbunden ist, um einen Strom über den ersten Schaltpfad zu übertragen,
wobei der Signaleingang des ersten Paares von Signaleingang und Signalausgang mit dem Steuereingang der jeweils anderen der gesteuerten Stromquelle (112) und der gesteuerten Stromsenke (118) verbunden ist, so dass die gesteuerte Stromquelle (112) oder Stromsenke (118) durch das über den ersten Schaltpfad übertragene Stromsignal (I₁₁₂) oder ein davon abgeleitetes Signal (U₁₁₆₎ ansteuerbar ist,
wobei ein gesteuerter Ausgang der anderen der gesteuerten Stromquelle (112) und Stromsenke (118) mit dem Signalausgang des zweiten Paares von Signaleingang und Signalausgang verbunden ist, um einen Strom über den zweiten Schaltpfad zu übertragen,
wobei der Signaleingang des zweiten Paares von Signaleingang und Signalausgang mit dem Stromrichtungselement (120) verbunden ist, welches dazu ausgebildet ist, ein von dem über den zweiten Schaltpfad übertragenen Strom abhängiges Signal (U₁₂₀) zu liefern, und wobei der Testsignalausgang (108) des Anschaltungsmoduls (26) mit dem Stromrichtungselement (120) verbunden ist, um das von dem Stromrichtungselement erzeugte Signal (U₁₂₀) oder ein davon abgeleitetes Signal als ausgehendes Testsignal des Sicherheitsteilnehmers (22) auszugeben.

2. Anschaltungsmodul nach Anspruch 1,
**dadurch gekennzeichnet, dass** das Stromrichtungselement (120) dazu eingerichtet ist, bei dem Erkennen eines nicht fehlerfreien Betriebs ein Signal mit einem dauerhaft im Wesentlichen konstanten Pegel auszugeben.

3. Anschaltungsmodul nach Anspruch 1 oder 2,
**dadurch gekennzeichnet, dass** die Testschaltung (62) dazu eingerichtet ist, zwischen dem Signaleingang des ersten Paares von Signaleingang und Signalausgang und dem Steuereingang der mit dem Signalausgang des zweiten Paares von Signaleingang und Signalausgang verbundenen gesteuerten Stromquelle (112) oder Stromsenke (118) eine Signalinvertierung durchzuführen derart, dass ein hoher Pegel des über den ersten Schaltpfad übertragenen Stromsignals (I₁₁₂) mit einem niedrigen Pegel des über den zweiten Schaltpfad übertragenen Stromsignals (I₁₁₈) korrespondiert und dass ein niedriger Pegel des über den ersten Schaltpfad übertragenen Stromsignals (I₁₁₂) mit einem hohen Pegel des über den zweiten Schaltpfad übertragenen Stromsignals (I₁₁₈) korrespondiert.

4. Anschaltungsmodul nach zumindest einem der vorstehenden Ansprüche,
**dadurch gekennzeichnet, dass** die Testschaltung (62) dazu eingerichtet ist, zwischen dem Testsignaleingang (106) und dem Steuereingang der mit dem Testsignaleingang verbundenen Stromquelle (112) oder Stromsenke (118) eine Signalinvertierung durchzuführen und/oder
dass die Testschaltung (62) dazu eingerichtet ist, zwischen dem Stromrichtungselement (120) und dem Testsignalausgang (108) eine Signalinvertierung durchzuführen.

5. Anschaltungsmodul nach zumindest einem der vorstehenden Ansprüche,
**dadurch gekennzeichnet, dass** zwischen dein Signaleingang des ersten Paares von Signaleingang und Signalausgang und dem Steuereingang der mit dem Signalausgang des zweiten Paares von Signaleingang und Signalausgang verbundenen Stromquelle (112) oder Stromsenke (118) ein Stromflusselement (114) der Testschaltung (62) angeordnet ist, welches dazu ausgebildet ist, an seinem Eingang das über den ersten Schaltpfad übertragene Stromsignal (I₁₁₂) zu empfangen und an seinem Ausgang ein Gleichspannungssignal (U₁₁₄) auszugeben, das von dem empfangenen Stromsignal (I₁₁₂) abhängt.

6. Anschaltungsmodul nach zumindest einem der vorstehenden Ansprüche,
**dadurch gekennzeichnet, dass**
zwischen dem Stromrichtungselement (120) und dem Testsignalausgang (108) eine Dynamikeinheit (122) der Testschaltung (62) angeordnet ist, die dazu eingerichtet ist, an ihrem Eingang das von dem Stromrichtungselement (120) ausgegebene Signal (U₁₂₀) oder ein davon abgeleitetes Signal zu empfangen und ein Signal auszugeben, dessen Form davon abhängt, ob das empfangene Signal (U₁₂₀) eine erwartete Dynamik aufweist.

7. Anschaltungsmodul nach zumindest einem der vorstehenden Ansprüche,
**dadurch gekennzeichnet, dass** die Testschaltung (62) aus diskreten Bauteilen aufgebaut ist.

8. Anschaltungsmodul nach zumindest einem der vorstehenden Ansprüche,
**dadurch gekennzeichnet, dass**
die Testschaltung (62) so ausgebildet ist, dass die Dynamik der durch die Testschaltung (62) erzeugten Signale (U₁₁₀, I₁₂₂, U₁₁₄, U₁₁₆, I₁₁₈, U₁₂₀) allein durch die Dynamik des eingehenden Testsignals (80) erzeugt wird, wobei die Testschaltung (62) des Anschaltungsmoduls (26) vorzugsweise keine von dem eingehenden Testsignal (80) unabhängige Zeitbasis aufweist.

9. Sicherheitssystem umfassend
- eine Sicherheitseinheit (10), insbesondere Sicherheitssteuerung, mit einem Ausgang (X1) und einem Sicherheitseingang (I1),
- eine zwischen dem Ausgang (X1) und dem Sicherheitseingang (11) der Sicherheitseinheit (10) angeordnete Busleitung (18),
- wenigstens einen an die Busleitung (18) angeschlossenen Sicherheitsteilnehmer (22), welcher ein an die Busleitung (18) angeschlossenes Anschaltungsmodul (26) nach zumindest einem der Ansprüche 1 bis 8 umfasst,
wobei die Busleitung (18) und der Sicherheitsteilnehmer (22) einen Testsignalpfad (36) mit einem mit dem Ausgang (X1) der Sicherheitseinheit (10) verbundenen Hinleitungspfad (38) und einem mit dem Sicherheitseingang (I1) der Sicherheitseinheit (10) verbundenen Rückleitungspfad (40) bilden, wobei der Testsignalpfad (36) den zwischen dem Testsignaleingang (106) und dem Testsignalausgang (108) angeordneten Testsignalpfad des Anschaltungsmoduls (26) umfasst,
wobei der Sicherheitsteilnehmer (22) ein über eine Anschaltungsleitung (30) mit dem Anschaltungsmodul (26) verbundenes und über das Anschaltungsmodul (26) in den Testsignalpfad (36) eingebundenes Schutzgerät (24) umfasst,
wobei das Schutzgerät (24) zwei Schalter (96a, 96b) umfasst, die jeweils über einen Hinleiter (98a, 98b) und einen Rückleiter (100a, 100b) der Anschaltungsleitung (30) und über eines der Paare von Signaleingang und Signalausgang des Anschaltungsmoduls (26) zur Bildung des ersten und zweiten elektrischen Schaltpfads mit dem Anschaltungsmodul (26) verbunden und in den Testsignalpfad (36) eingebunden sind.

10. Sicherheitssystem nach Anspruch 9,
**dadurch gekennzeichnet, dass**
das Sicherheitssystem dazu eingerichtet ist, ein dynamisches Testsignal (80) zu erzeugen und über den Testleitungspfad (36) zu dem Testsignaleingang (106) des Sicherheitsteilnehmers (22) zu übertragen, welches als binärwertiges Gleichstrom- oder Gleichspannungssignal ausgebildet ist, das zwischen einem vorgegebenen hohen und einem vorgegebenen niedrigen Strom- oder Spannungspegel wechselt.

11. Sicherheitssystem nach Anspruch 9 oder 10,
**dadurch gekennzeichnet, dass**
das Stromrichtungselement (120) dazu eingerichtet ist, zu erkennen, wenn an dem Stromrichtungselement (120) ein Stromfluss mit einer der Erwartung bei fehlerfreiem Betrieb des Sicherheitsteilnehmers (22) entgegen gesetzten Richtung vorliegt und in diesem Fall vorzugsweise ein Signal auszugeben, welches zu dem Ansprechen einer Sicherheitsfunktion der Sicherheitseinheit (10) führt.

12. Sicherheitssystem nach zumindest einem der Ansprüche 9 bis 11,
**dadurch gekennzeichnet, dass**
das Stromrichtungselement (120) dazu eingerichtet ist, zu erkennen, wenn an dem Stromrichtungselement (120) ein Stromfluss vorliegt, dessen Wert sich zumindest für eine bestimmte Zeit von den bei fehlerfreiem Betrieb erwarteten Strompegeln unterscheidet, und in diesem Fall vorzugsweise ein Signal auszugeben, welches zu dem Ansprechen einer Sicherheitsfunktion der Sicherheitseinheit (10) führt.

13. Sicherheitssystem nach zumindest einem der Ansprüche 9 bis 12,
**dadurch gekennzeichnet, dass**
das Schutzgerät (24) dazu ausgebildet ist, die beiden Schalter (96a, 96b) bei dem Eintreten eines nicht sicheren Zustands des Schutzgeräts (24) gemeinsam zu öffnen und dadurch den zugehörigen elektrischen Schaltpfad zu unterbrechen, wobei der Sicherheitsteilnehmer (22) einen in dem Testsignalpfad (36) angeordneten Unterbrechungsschalter (66) und eine Auswerteeinheit (50) umfasst, die mit dem ersten und zweiten Schaltpfad verbunden ist und die dazu eingerichtet ist, zu überprüfen, ob der erste und zweite Schaltpfad gemeinsam unterbrochen werden, und um den Unterbrechungsschalter (66) zu öffnen, wenn die zwei Schaltpfade nicht gemeinsam unterbrochen werden.

14. Sicherheitssystem nach zumindest einem der Ansprüche 9 bis 13,
**dadurch gekennzeichnet, dass**
das Sicherheitssystem wenigstens einen weiteren an die Busleitung (18) angeschlossenen und ein Schutzgerät (24) umfassenden Sicherheitsteilnehmer (22) umfasst, der derart eingerichtet sind, dass das Vorliegen eines nicht sicheren Zustands seines Schutzgeräts (24) eine Unterbrechung des Testsignalpfads (36) bewirkt,
wobei die Sicherheitsteilnehmer (22) entlang der Busleitung (18) so in einer Linie angeordnet sind, dass sowohl der Hinleitungspfad (38) als auch der Rückleitungspfad (40) des Testsignalpfads (36) durch dieselben Sicherheitsteilnehmer (22) hindurch verlaufen,
wobei das Sicherheitssystem ein an dem Ende der Linie angeschlossenes, den Hinleitungspfad (38) und den Rückleitungspfad (40) des Testsignalpfads (36) verbindendes Abschlusselement (32) umfasst, wobei die Sicherheitseinheit (10) dazu ausgebildet ist, an ihrem mit dem Hinleitungspfad (38) verbundenen Ausgang (X1) ein Ausgangssignal auszusenden, und
wobei das Abschlusselement (32) dazu ausgebildet ist, das Ausgangssignal von dem Hinleitungspfad (38) zu empfangen und in Abhängigkeit von dem von dem Hinleitungspfad (38) empfangenen Ausgangssignal ein gegenüber dem empfangenen Ausgangssignal verändertes Testsignal an den Rückleitungspfad (40) des Testsignalpfads (36) auszugeben.

## Claims

1. An interconnection module (26) for integrating a protective device (24) in a safety system, which comprises
- at least one test signal path which is arranged between a test signal input (106) for an incoming test signal (80) and a test signal output (108) for an outgoing test signal of the interconnection module (26);
- a first and a second pair of a respective signal input and a respective signal output, wherein the signal input and the signal output of a pair are respectively configured for the integration of an electric switching path into the test signal path; and
- a test circuit (62) for the two switching paths;
**characterized in that**
the test circuit (62) comprises a controlled current source (112), a controlled current sink (118) and a current direction element (120); wherein the test signal input (106) of the interconnection module (26) is connected to a control input of the controlled current source (112) or of the controlled current sink (118) in such a way that the controlled current source (112) or current sink (118) can be controlled by the incoming test signal (80) or by a signal (U₁₁₀) derived therefrom and wherein a controlled output of the same from the current source (112) and the current sink (118) is connected to the signal output of the first pair of signal output and signal input in order to transmit a current via the first switching path;
wherein the signal input of the first pair of signal input and signal output is connected to the control input of the respective other one of the controlled current source (112) and of the controlled current sink (118) in such a way that the controlled current source (112) or current sink (118) can be controlled through the current signal (I₁₁₂) transmitted via the first switching path or through a signal (U₁₁₆) derived therefrom;
wherein a controlled output of the other one of the controlled current source (112) and current sink (118) is connected to the signal output of the second pair of signal input and signal output in order to transmit a current via the second switching path;
wherein the signal input of the second pair of signal input and signal output is connected to the current direction element (120) which is configured to provide a signal (U₁₂₀) in dependence on the current transmitted via the second switching path; and
wherein the test signal output (108) of the interconnection module (26) is connected to the current direction element (120) in order to output the signal (U₁₂₀) generated by the current direction element or a signal derived therefrom as an outgoing test signal of the safety related participant (22).

2. An interconnection module in accordance with claim 1,
**characterized in that**
the current direction element (120) is adapted to output a signal having a continuously substantially constant level on the recognition of a non error-free operation.

3. An inter connection module in accordance with claim 1 or claim 2,
**characterized in that**
the test circuit (62) is adapted to carry out a signal inversion between the signal input of the first pair of signal input and signal output and the control input of the controlled power source (112) or current sink (118) connected to the signal output of the second pair of signal input and signal output such that that a high level of the current signal (I₁₁₂) transmitted via the first switching path corresponds to a low level of the current signal (I₁₁₈) transmitted via the second switching path and such that a low level of the current signal (I₁₁₂) transmitted via the first switching path corresponds to a high level of the current signal (I₁₁₈) transmitted via the second switching path.

4. An interconnection module in accordance with at least one of the preceding claims,
**characterized in that**
the test circuit (62) is adapted to carry out a signal inversion between the test signal input (106) and the control input of the current source (112) or current sink (118) connected to the test signal input; and/or
**in that** the test circuit (62) is adapted to carry out a signal inversion between the current direction element (120) and the test signal output (108).

5. An interconnection module in accordance with at least one of the preceding claims,
**characterized in that**
a current flow element (114) of the test circuit (62) is arranged between the signal input of the first pair of signal input and signal output and the control input of the current source (112) or current sink (118) connected to the signal output of the second pair of signal input and signal output, said control flow element being configured to receive the current signal (I₁₁₂) transmitted via the first switching path at its input and to output a direct voltage signal (U₁₁₄) which is dependent on the received current signal (I₁₁₂) at its output.

6. An interconnection module in accordance with at least one of the preceding claims,
**characterized in that**
a dynamic unit (122) of the test circuit (62) is arranged between the current direction element (120) and the test signal output (108) which dynamic unit is adapted to receive the signal (U₁₂₀) output by the current direction element (120) or a signal derived therefrom at its input and to output a signal whose shape depends on whether the received signal (U₁₂₀) has an expected dynamic.

7. An interconnection module in accordance with at least one of the preceding claims,
**characterized in that**
the test circuit (62) is assembled from discrete components.

8. An interconnection module in accordance with at least one of the preceding claims,
**characterized in that**
the test circuit (62) is configured in such a way that the dynamic of the signals (U₁₁₀, I₁₁₂, U₁₁₄, U₁₁₆, I₁₁₈, U₁₂₀) generated by the test circuit (62) is generated purely by the dynamic of the incoming test signal (80), wherein the test circuit (62) of the interconnection module (26) preferably has no time base independent of the incoming test signal (80).

9. A safety system comprising
- a safety unit (10), in particular a safety control, having an output (X1) and a safety input (I1);
- a bus line (18) arranged between the output (X1) and the safety input (I1) of the safety unit (10);
- at least one safety related participant (22) connected to the bus line (18), the safety related participant comprising an interconnection module (26) in accordance with at least one of the claims 1 to 8 which is connected to the bus line (18);
wherein the bus line (18) and the safety related participant (22) form a test signal path (36) having a forward path (38) connected to the output (X1) of the safety unit (10) and a return path (40) connected to the safety input (I1) of the safety unit (10), wherein the test signal path (36) comprises the test signal path of the interconnection module (26) arranged between the test signal input (106) and the test signal output (108);
wherein the safety related participant (22) comprises a protective device (24) connected to the interconnection module (26) via an interconnection line (30) and integrated in the test signal path (36) by means of the interconnection module (26);
wherein the protective device (24) comprises two switches (96a, 96b) which are respectively connected to the interconnection module (26) via a forward line (98a, 98b) and a return line (100a, 100b) of the interconnection line (30) and are connected to the interconnection module (26) via one of the pairs of signal input and signal output of the interconnection module (26) for the formation of the first and second electric switching paths and which are integrated in the test signal path (36).

10. A safety system in accordance with claim 9,
**characterized in that**
the safety system is adapted to generate a dynamic test signal (80) and to transmit it to the test signal input (106) of the safety related participant (22) via the test signal path (36), which test signal is configured as a binary direct current or direct voltage signal which alternates between a predefined high and a predefined low current level or voltage level.

11. A safety system in accordance with claim 9 or claim 10,
**characterized in that**
the current direction element (120) is adapted to recognize when a current flow is present at the current direction element (120), the current flow having a direction which is opposite to the direction expected on an error-free operation of the safety related participant (22) and preferably to output a signal in this case, said signal leading to an activation of a safety function of the safety unit (10).

12. A safety system in accordance with at least one of the claims 9 to 11,
**characterized in that**
the current direction element (120) is adapted to recognize when a current flow is present at the current direction element (120) whose value differs at least for a certain period of time from the current levels expected during an error-free operation and preferably to output a signal in this case, said signal leading to the activation of a safety function of the safety unit (10).

13. A safety system in accordance with at least one of the claims 9 to 12,
**characterized in that**
the protective device (24) is configured to open the two switches (96a, 96b) together on the occurrence of a non-secure state of the protective device (24) and thereby to interrupt the associated electric switching path, wherein
the safety related participant (22) comprises an interruption switch (66) arranged in the test signal path (36) and an evaluation unit (50) which is connected to the first and the second switching path and which is adapted to check whether the first and the second switching path are interrupted together and to open the interruption switch (66) when the two switching paths are not interrupted together.

14. A safety system in accordance with at least one of the claims 9 to 13,
**characterized in that**
the safety system comprises at least one further safety related participant (22) connected to the bus line (18) and comprising a protective device (24), which safety related participant is adapted in such a way that the presence of a non-secure state of its protective device (24) brings about an interruption of the test signal path (36); wherein the safety related participants (22) are arranged along the bus line (18) in a line in such a way that both the forward path (38) and also the return path (40) of the test signal path (36) run through the same safety related participants (22);
wherein the safety system comprises a termination element (32) connected at the end of the line and connecting the forward path (38) and the return path (40) of the test signal path (36); wherein the safety unit (10) is configured to transmit an output signal at its output (X1) connected to the forward path (38); and
wherein the termination element (32) is configured to receive the output signal from the forward path (38) and to output a test signal to the return path (40) of the test signal path (36) in dependence on the output signal received from the forward path (38), said test signal being changed with respect to the received output signal.

## Revendications

1. Module de sélection (26) pour l'intégration d'un appareil de protection (24) dans un système de sécurité, qui comprend
- au moins un trajet de signal test, agencé entre une entrée de signal test (106) pour un signal test entrant (80) et une sortie de signal test (108) pour un signal test sortant du module de sélection (26),
- une première et une seconde paire formées chacune d'une entrée de signal et d'une sortie de signal, ladite entrée de signal et ladite sortie de signal d'une paire étant respectivement réalisées pour l'intégration d'un trajet de commutation électrique dans le trajet de signal test, et
- un circuit test (62) pour les deux trajets de commutation,
**caractérisé en ce que**
le circuit test (62) comprend une source de courant commandée (112), un consommateur de courant commandé (118) et un élément à direction de courant (120),
dans lequel l'entrée de signal test (106) du module de sélection (26) est reliée à une entrée de commande de la source de courant commandée (112) ou du consommateur de courant commandé (118), de sorte que la source de courant commandée (112) ou le consommateur de courant commandé (118) est susceptible d'être piloté(e) par le signal test entrant (80) ou par un signal (U₁₁₀) dérivé de celui-ci, et dans lequel une sortie commandée de ladite source de courant (112) ou du consommateur de courant (118) est reliée à la sortie de signal de la première paire formée d'une sortie de signal et d'une entrée de signal, afin de transmettre un courant via le premier trajet de commutation,
dans lequel l'entrée de signal de la première paire formée d'une entrée de signal et d'une sortie de signal est reliée à l'entrée de commande de l'autre parmi la source de courant commandée (112) et le consommateur de courant commandé (118) respectivement, de sorte que la source de courant commandée (112) ou le consommateur de courant commandé (118) est susceptible d'être piloté(e) par le signal de courant (I112) transmis via le premier trajet de commutation ou par un signal (U₁₁₆) dérivé de celui-ci,
dans lequel une sortie commandée de l'autre parmi la source de courant commandée (112) et le consommateur de courant commandé (118) est reliée à la sortie de signal de la seconde paire formée d'une entrée de signal et d'une sortie de signal, afin de transmettre un courant via le second trajet de commutation,
dans lequel l'entrée de signal de la seconde paire formée d'une entrée de signal et d'une sortie de signal est reliée à l'élément à direction de courant (120), lequel est réalisé pour délivrer un signal (U₁₂₀) dépendant du courant transmis via le second trajet de commutation, et dans lequel la sortie de signal test (108) du module de sélection (26) est reliée à l'élément à direction de courant (120), afin de délivrer, à titre de signal test sortant de l'élément participant (22) à la sécurité, le signal (U₁₂₀) engendré par l'élément redresseur de courant ou un signal dérivé de celui-ci.

2. Module de sélection selon la revendication 1,
**caractérisé en ce que** l'élément à direction de courant (120) est conçu pour délivrer, lors de la reconnaissance d'un fonctionnement qui n'est pas exempt de défauts, un signal avec un niveau durable essentiellement constant.

3. Module de sélection selon la revendication 1 ou 2,
**caractérisé en ce que** le circuit test (62) est conçu pour exécuter une inversion de signal entre l'entrée de signal de la première paire formée d'une entrée de signal et d'une sortie de signal et l'entrée de commande de la source de courant commandée (112) ou du consommateur de courant commandé (118) relié(e) à la sortie de signal de la seconde paire formée d'une entrée de signal et d'une sortie de signal, de telle façon qu'un niveau élevé du signal de courant (I₁₁₂) transmis via le premier trajet de commutation correspond à un niveau faible du signal de courant (I₁₁₈) transmis via le second trajet de commutation, et qu'un niveau faible du signal de courant (I₁₁₂) transmis via le premier trajet de commutation correspond à un niveau élevé du signal de courant (I₁₁₈) transmis via le second trajet de commutation.

4. Module de sélection selon l'une au moins des revendications précédentes,
**caractérisé en ce que**
le circuit test (62) est conçu pour exécuter une inversion de signal entre l'entrée de signal test (106) et l'entrée de commande de la source de courant (112) ou du consommateur de courant (118) relié(e) à l'entrée de signal test, et/ou
**en ce que** le circuit test (62) est conçu pour exécuter une inversion de signal entre l'élément à direction de courant (120) et la sortie de signal test (108).

5. Module de sélection selon l'une au moins des revendications précédentes,
**caractérisé en ce que**, entre l'entrée de signal de la première paire formée d'une entrée de signal et d'une sortie de signal et l'entrée de commande de la source de courant (112) ou du consommateur de courant (118) relié(e) à la sortie de signal de la seconde paire formée d'une entrée de signal et d'une sortie de signal, est agencé un élément de passage de courant (114) du circuit test (62), lequel est réalisé pour recevoir à son entrée le signal de courant (I₁₁₂) transmis via le premier trajet de commutation, et pour délivrer à sa sortie un signal à tension continue (U₁₁₄), qui dépend du signal de courant (I₁₁₂) reçu.

6. Module de sélection selon l'une au moins des revendications précédentes,
**caractérisé en ce que**, entre l'élément à direction de courant (120) et la sortie de signal test (108), est agencée une unité dynamique (122) du circuit test (62), laquelle est conçue pour recevoir à son entrée le signal (U₁₂₀) délivré par l'élément à direction de courant (120) ou un signal dérivé de celui-ci, et pour délivrer un signal dont la forme dépend de ce que le signal reçu (U₁₂₀) présente une dynamique attendue.

7. Module de sélection selon l'une au moins des revendications précédentes,
**caractérisé en ce que** le circuit test (62) est constitué de composants discrets.

8. Module de sélection selon l'une au moins des revendications précédentes,
**caractérisé en ce que** le circuit test (62) est réalisé de telle façon que la dynamique des signaux(U₁₁₀, I₁₁₂, U₁₁₄, U₁₁₆, I₁₁₂, U₁₂₀) engendré par le circuit test (62) est engendrée uniquement par la dynamique du signal test entrant (80), le circuit test (62) du module de sélection (26) ne présentant de préférence aucune base temporelle indépendante du signal test entrant (80).

9. Système de sécurité comprenant
- une unité de sécurité (10), en particulier une commande de sécurité, avec une sortie (X1) et une entrée de sécurité (I1),
- une ligne de bus (18) agencée entre la sortie (X1) et l'entrée de sécurité (I1) de l'unité de sécurité (10),
- au moins un participant de sécurité (22) raccordé à la ligne de bus (18), qui comprend un module de sélection (26) selon l'une au moins des revendications 1 à 8, raccordé à la ligne de bus (18),
dans lequel la ligne de bus (18) et le participant de sécurité (22) forment un trajet de signal test (36) avec un trajet de ligne arrivant (38) relié à la sortie (X1) de l'unité de sécurité (10) et un trajet de ligne de retour (40), relié à l'entrée de sécurité (I1) de l'unité de sécurité (10), dans lequel le trajet de signal test (36) inclut le trajet de signal test, agencé entre l'entrée de signal test (106) et la sortie de signal test (108), du module de sélection (26),
dans lequel le participant de sécurité (22) inclut un appareil de protection (24) relié via une ligne de sélection (30) au module de sélection (26) et intégré dans le trajet de signal test (36) via le module de sélection (26),
dans lequel l'appareil de protection (24) inclut deux commutateurs (96a, 96b) qui sont respectivement reliés au module de sélection (26) et intégrés dans le trajet de signal test (36) via une ligne d'arrivée (98a, 98b) et une ligne de retour (100a, 100b) de la ligne de sélection (30) et via l'une des paires formées d'une entrée de signal et d'une sortie de signal du module de sélection (26) pour constituer le premier et le second trajet de commutation électrique.

10. Système de sécurité selon la revendication 9,
**caractérisé en ce que** le système de sécurité est conçu pour engendrer un signal test dynamique (80) et le transmettre via le trajet de ligne test (36) à l'entrée de signal test (106) du participant de sécurité (22), ce signal test étant réalisé sous forme d'un signal à courant continu ou à tension continue de valeur binaire, qui alterne entre un niveau de courant ou un niveau de tension élevé prédéterminé et un niveau de courant ou un niveau de tension faible prédéterminé.

11. Système de sécurité selon la revendication 9 ou 10,
**caractérisé en ce que** l'élément à direction de courant (100) est conçu pour reconnaître s'il se présente au niveau de l'élément à direction de courant (100) un flux de courant avec une direction opposée à celle qui est attendue pour un fonctionnement sans erreur du participant de sécurité (22) et dans ce cas, pour délivrer de préférence un signal qui mène à la réaction d'une fonction de sécurité de l'unité de sécurité (10).

12. Système de sécurité selon l'une au moins des revendications 9 à 11,
**caractérisé en ce que** l'élément à direction de courant (100) est conçu pour reconnaître s'il se présente au niveau de l'élément à direction de courant (100) un flux de courant dont la valeur diffère au moins pendant un temps déterminé du niveau de courant attendu pour un fonctionnement sans erreur et dans ce cas, pour délivrer de préférence un signal qui mène à la réaction d'une fonction de sécurité de l'unité de sécurité (10).

13. Système de sécurité selon l'une au moins des revendications 9 à 12,
**caractérisé en ce que** l'appareil de protection (24) est réalisé pour ouvrir conjointement les deux commutateurs (96a, 96b) lors de l'apparition d'une situation hors sécurité de l'appareil de protection (24) et pour interrompre de ce fait le trajet de commutation électrique associé, dans lequel le participant de sécurité (22) inclut un commutateur interrupteur (66) agencé dans le trajet de signal test (36) et une unité d'évaluation (50), qui est reliée au premier trajet de commutation et au second trajet de commutation et conçue pour contrôler si le premier trajet de commutation et le second trajet de commutation sont conjointement interrompus, et pour ouvrir le commutateur interrupteur (66) quand les deux trajets de commutation ne sont pas conjointement interrompus.

14. Système de sécurité selon l'une au moins des revendications 9 à 13, **caractérisé en ce que** le système de sécurité inclut au moins un autre participant de sécurité (22) raccordé à la ligne de bus (18) et comprenant un appareil de protection (24), lequel est conçu de telle manière que la présence d'une situation hors sécurité de son appareil de protection (24) provoque une interruption du trajet de signal test (36), dans lequel les participants de sécurité (22) sont agencés le long de la ligne de bus (18) en formant une ligne de telle façon que le trajet de ligne d'arrivée (38) tout comme le trajet de ligne de retour (40) du trajet de signal test (36) passent à travers les mêmes participants de sécurité (22),
dans lequel le système de sécurité inclut un élément de terminaison (32) raccordé à l'extrémité de la ligne et reliant le trajet de ligne d'arrivée (38) et le trajet de ligne de retour (40) du trajet de signal test (36),
dans lequel l'unité de sécurité (10) est réalisée pour émettre à sa sortie (X1) reliée au trajet de ligne d'arrivée (38) un signal sortant, et
dans lequel l'élément de terminaison (32) est réalisé pour recevoir le signal sortant depuis le trajet de ligne d'arrivée (38) et, en fonction du signal sortant reçu par le trajet de ligne d'arrivée (38), pour émettre vers le trajet de ligne de retour (40) du trajet de signal test (36) un signal test modifié par rapport au signal sortant reçu.
